(19) Europäisches Patentamt
European Patent Office
Office européen des brevets

(11) EP 1 826 613 A2

(12) **EUROPEAN PATENT APPLICATION**

(43) Date of publication:
**29.08.2007 Bulletin 2007/35**

(51) Int Cl.:
***G03F 7/075*** *(2006.01)* ***G03F 7/11*** *(2006.01)*
***G03F 7/20*** *(2006.01)*

(21) Application number: **07003658.7**

(22) Date of filing: **22.02.2007**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **22.02.2006 US 776610 P**
**15.02.2007 US**

(71) Applicant: **Air Products and Chemicals, Inc.**
**Allentown, PA 18195-1501 (US)**

(72) Inventors:
- **Weigel, Scott Jeffrey**
  **Allentown, PA 18104 (US)**
- **Zhang, Peng**
  **Qaukertown, PA 18951 (US)**
- **Braymer, Thomas Albert**
  **Allentown, PA 18103 (US)**
- **Parris, Gene Everad**
  **Coppersburg , PA 18036 (US)**

(74) Representative: **Schwabe - Sandmair - Marx**
**Stuntzstrasse 16**
**81677 München (DE)**

(54) **Top coat for lithography processes**

(57) The present invention provides a top coat composition comprising a silicon-containing polymer prepared by hydrolysis and condensation of at least one silica source; a solvent; optionally a catalyst; and optionally water, wherein the silicon-containing polymer depolymerizes upon exposure to an aqueous base-containing solution.

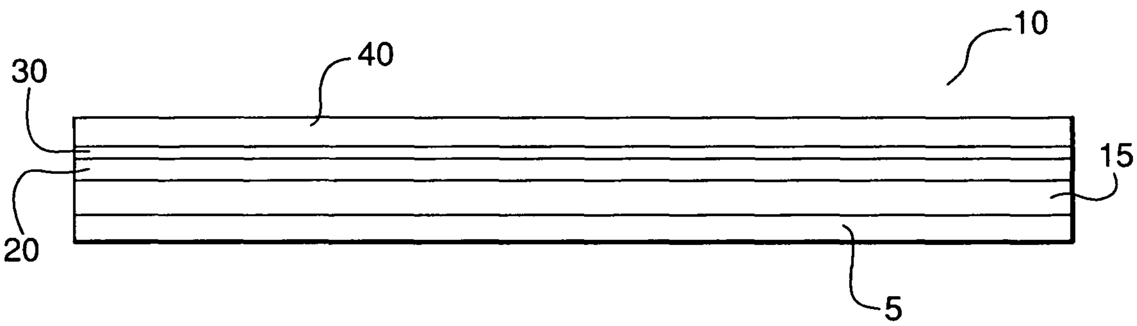


FIG. 1

EP 1 826 613 A2

**Description**

CROSS-REFERENCE TO RELATED APPLICATIONS

This application claims the benefit of priority under 35 U.S.C. § 119(e) to earlier filed U.S. patent application Serial No. 60/776,610, filed on February 22, 2006, the disclosure of which is incorporated by reference in its entirety.

BACKGROUND OF THE INVENTION

The present invention relates to a top coat material and the use thereof in lithography processes. More particularly, the present invention is directed to a top coat material that is easy to apply, insoluble in water and depolymerizes in an aqueous base-containing developer. The top coat of the present invention is useful for dry lithographic processes as well as for immersion lithography in which a liquid such as, for example, water is used as the exposure medium between the lens fixture of an exposure tool and the photoresist-coated wafer.

Photolithography is a process used for making miniaturized electronic components such as in the fabrication of computer chips and integrated circuits. Generally, in this process, a thin coating of a film of a photoresist composition is first applied to a substrate material, such as silicon wafers used for making integrated circuits. The coated substrate is then baked to evaporate any solvent in the photoresist composition and to fix the coating onto the substrate. The photoresist coated on the substrate is next subjected to an image-wise exposure to radiation.

The radiation exposure causes a chemical transformation in the exposed areas of the coated surface. Visible light, ultraviolet (UV) light, electron beam and X-ray radiant energy are radiation types commonly used today in microlithographic processes. After this image-wise exposure, the coated substrate is treated with a developer solution to dissolve and remove either the radiation exposed or the unexposed areas of the photoresist.

The trend towards the miniaturization of semiconductor devices has led to the development of immersion lithography. Immersion lithography may offer better resolution enhancement and higher numerical apertures at a given exposure wavelength over conventional projection lithography. For example, immersion lithography could extend lithography at the 193 nm wavelength down to the 45 nm node and below thereby providing an alternative to 157 nm exposure wavelengths, extreme ultraviolet (EUV), and other potential technologies.

The minimum feature width (W) that may be printed with an optical lithography system is determined by the Rayleigh equation: $W = (k_1\lambda) / (NA)$ where $k_1$ is the resolution factor, $\lambda$ is the wavelength of the exposing radiation and NA is the numerical aperture. Numerical aperture (NA) is determined using the equation: $NA = n \sin \alpha$ where n is the index of refraction of the medium surrounding the lens and $\alpha$ is the acceptance angle of the lens. The physical limit to NA for exposure systems using air as a medium between the lens and the wafer is 1. Air is the least desirable medium because its index of refraction may cause a relatively high amount of bending when light leaves the glass. Since the index of refraction for water and glass is approximately 1.44 and 1.52 respectively, far less bending occurs thereby providing a sharper and deeper focus.

In immersion lithography, the space between the lens and the substrate is filled with a liquid, referred to herein as an immersion fluid, that has a refractive index greater than 1. The immersion fluid should preferably exhibit a low optical absorption at the operating wavelength such as, for example 193 nm and 157 nm, be compatible with the photoresist and the lens material, be uniform and be non-contaminating. A preferred immersion fluid for 193nm immersion lithography is ultra pure water. Ultra pure water has an index of refraction of approximately 1.44, exhibits absorption of less than 5% at working distances of up to 6 mm, is compatible with photoresist and lens, and is non-contaminating in its ultra pure form. Applying the Rayleigh equation using n=1.44 and assuming $\sin \alpha$ can reach 0.93, the feature width for 193 nm could reach a theoretical minimum resolution of 36 nm. In short, increasing the refractive index of the medium between the lens and the photoresist allows for greater resolution power and depth of focus. This, in turn, gives rise to greater process latitudes in the manufacturing of IC devices.

A significant concern in immersion lithography is the extraction of components from the photoresist film into the immersion fluid. These components may either be present in the resist film prior to exposure (e.g., base additives, photoacid generators, solvent, dissolution inhibitors, plasticizers, leveling agents, and quenchers) or present in the resist film during or shortly after exposure (e.g., photoacid, photoacid generator, photofragments, scission fragments from the polymer or the other additives, salt of the photoacid and base additive). The extraction of these materials is of concern for at least two reasons. First, the extracted materials may affect resist performance deleteriously. Second, the lens in contact with the immersion fluid often becomes contaminated by the formation of a UV-absorbing film that forms when the extracted materials photoreact with each other.

A top coat is typically employed as a layer between the immersion liquid and the resist-coated substrate to prevent photoresist components from leaching into the immersion liquid. A top coat layer can also prevent the permeation of the immersion liquid into the photoresist film.

Top coat materials have been used traditionally in photolithography as anti-reflective films on the top of a

photoresist. The top anti-reflective coat (TARC) materials can prevent the multiple interference of light that takes place within the photoresist layer during exposure. As a result, the critical dimension (CD) variation of the geometrical features of a photoresist pattern that is caused by the variation in the thickness of the photoresist film can be minimized.

To fully take advantage of the anti-reflective effect of the top coat, the refractive index of the top coat material ($n_t$) should be at about the square root of the multiplication of the refractive index of the exposure medium ($n_m$) and the refractive index of the underlying photoresist ($n_r$). If the exposure medium is air, as in the case for "dry" lithography, the optimal refractive index of the top coat material ($n_t$) should be at about the square root of the refractive index of the underlying photoresist ($n_r$) because the refractive index of air is roughly 1.

It is preferable that the top coat material is inert to the immersion liquid but is readily removable in conventional aqueous base-containing developer solutions. Top coat materials such as, for example, those listed in U.S. patent application Publication Nos. US 2005/0202347 A1 and US 2005/0202340 A1 have been developed that employ organic polymers that are soluble in aqueous base-containing developer solutions. Use of such soluble organic polymers, however, can precipitate out of solution and lead to at least one of the aforementioned problems. Moreover, the prior art soluble organic polymers typically absorb light at wavelengths greater than 193 nm, which decreases the intensity of radiation that is needed by the photoresist. This typically results in longer exposure times at greater power levels.

Another drawback associated with immersion lithography is defectivity. There are many types of immersion-related defects such as, for example, bubbles, watermarks, drying stains, bridging defects and surface particles. Such defects may come from a variety of sources, including contaminants from tool construction materials and topcoat/resist residues. Recently, significant progress has been made in reducing the defect level, including modifying the scanner shower head configuration and improving the compositions of resists and topcoats. However, there is still no viable solution for watermark defects that occur when water droplets remain on the surface after the wafer exposure. These droplets can penetrate through the topcoat resulting in photo acids as well as other resist components leaching out thereby forming watermark defects.

Recent work has related watermark defects to topcoat hydrophobicity, indicating that a more hydrophobic topcoat tends to generate less watermark defects. However, it has been a challenge to increase the topcoat hydrophobicity while maintaining the fast dissolution rate in the photoresist developer. In addition, such hydrophobic topcoat may have a higher tendency towards re-precipitation during a DI water rinse step thereby leaving topcoat residue defects.

Thus, there remains a need for a top coat material suitable for use in immersion lithography that is inert in the immersion fluid, but removable in the aqueous base-containing developer yet does not suffer from the aforementioned drawbacks.

## BRIEF SUMMARY OF THE INVENTION

The present invention satisfies this need by providing a top coat composition comprising a silicon-containing polymer prepared by hydrolysis and condensation of at least one silica source; a solvent; optionally a catalyst; and optionally water, wherein the silicon-containing polymer depolymerizes upon exposure to an aqueous base-containing solution.

In another aspect, the present invention provides a method for making a depolymerizable top coat material for use in a lithographic process, the method comprising: applying a layer of a composition adjacent to a layer of photoresist, the composition comprising a silicon-containing polymer prepared by sol-gel processing at least one silica source; and subjecting the layer of top coat material to a temperature of from about 50 to about 200°C, wherein the silicon-containing polymer in the top coat material depolymerizes upon exposure to an aqueous base-containing solution.

In another aspect, the present invention provides a method for forming a patterned layer on an article, the method comprising: providing an article comprising a material layer; forming a photoresist layer on the material layer; applying a top coat material adjacent to the photoresist layer, thereby forming a coated article, the top coat material comprising a silicon-containing polymer prepared by sol-gel processing at least one silica source; exposing the photoresist layer to imaging irradiation through a patterned mask and through the top coat material; contacting the article with an aqueous base-containing solution to remove simultaneously the top coat material and portions of the photoresist layer, thereby forming a patterned photoresist layer on the material layer; and transferring the pattern in the photoresist layer to the material layer, wherein the polymer component of the top coat material is depolymerized upon contact with the aqueous base-containing solution.

In yet another aspect, the present invention provides a top coat for use in a lithographic process prepared by: applying a layer of a composition adjacent to a layer of photoresist, the composition comprising a silicon-containing polymer prepared by sol-gel processing at least one silica source, wherein the layer is ready for use as a top coat; and optionally subjecting the layer of top coat material to a temperature of from about 50 to about 200°C, wherein the silicon-containing polymer in the top coat material depolymerizes upon exposure to an aqueous base-containing solution.

BRIEF DESCRIPTION OF THE DRAWINGS

The numerous advantages of the present invention may be better understood by those skilled in the art by reference to the accompanying figures in which like numerals represent like elements, and in which:

FIG. 1 illustrates a substrate according to the present invention; and

FIG. 2 and FIG. 3 illustrate a conventional substrate and a substrate according to an embodiment of the present invention, respectively, under a projection system during imaging.

DETAILED DESCRIPTION OF THE INVENTION

The present invention is directed to a top coat material comprising a silicon-containing polymer that is insoluble in water and removable by depolymerization in an aqueous base-containing developer solution so that it can be used for 193 nm immersion lithography. Additionally, the top coat material of the present invention can be adjusted to act as a TARC so that better process control of image formation can be achieved because a TARC is capable of absorbing reflected light to aid in the resolution of fine features. The top coat of the present invention can be modified to become a TARC by adding at least one chromophore into the compositions described below. Examples of suitable chromophores include, for example, 5,8-dihydroxy-1,4-napthoquinone and 2,4-hexadienoic acid, each of which are capable of absorbing 193 nm light used in immersion lithography. For 193 nm immersion lithography using water as the exposure medium, the optimal refractive index for a TARC material is about 1.5 to 1.7.

FIG. 1 depicts an article 10 that is ready for lithographic processing such as, for example, in an immersion lithography process. Article 10 includes substrate 5. Suitable substrates include, but are not limited to, materials such as gallium arsenide ("GaAs"), silicon, tantalum, copper, ceramics, aluminum/copper alloys, polyimides, and compositions containing silicon such as crystalline silicon, polysilicon, amorphous silicon, epitaxial silicon, silicon dioxide ("$SiO_2$"), silicon nitride, doped silicon dioxide, and the like. Further exemplary substrates include silicon, aluminum, or polymeric resins. Article 10 also includes at least one material layer 15. At least one material layer 15 is a layer that is to be patterned after a mask is formed by the photolithographic process. At least one material layer 15 preferably comprises a ceramic, dielectric (low or high), metal or semiconductor layer, such as those used in the manufacture of high performance integrated circuit devices and associated chip carrier packages.

Referring again to FIG. 1, a layer of resist 20 is present on top of the surface of the at least one material layer 15. The resist may be either positive or negative. In a positive photoresist coating, the areas masked from radiation remain after development while the exposed areas are dissolved away. In a negative photoresist coating, the opposite occurs.

Still referring to FIG. 1, a layer 30 of protective material is present above the resist to protect it from contaminants. This layer 30 of protective material is thin, *i.e.*, typically less than one wavelength of the radiation of the projection beam. In this embodiment, it is approximately 50 nm thick. A material 40 (or top coat material) according to the present invention is applied by a coating system (described in more detail below) as a top coat on top of the protective layer 30. This can be done at any time after the protective layer is applied until the substrate enters the projection area of the lithographic apparatus. Top coat material 40 is preferably non-photosensitive and is at least partially transparent to radiation of the wavelength of the projection beam. In some embodiments of the present invention, the coating transmits as much of the radiation of the projection beam as possible to allow patterning of the photoresist material. It is preferable that the top coat material have a refractive index in the range of about 1.2 to 1.8. For 193 nm immersion lithography using water as the exposure medium, the refractive index of the top coat material is most preferably in the range of about 1.5 to 1.7.

Top coat material 40 can also act as a chemical barrier for environmental contaminants, in that case the protective layer 30 is not needed.

According to the present invention, top coat material 40 is preferably insoluble in water but is removable by depolymerization in an aqueous base-containing solution that is typically referred to as a "developer" by those skilled in the art. As used herein, the term "depolymerizable" as it refers to top coat material 40 refers to the breakdown of the polymeric components of the material into simpler components such as, e.g., oligomers and monomers. The oligomer and monomer components, in turn, are preferably soluble in the aqueous base-containing developer.

Top coat material 40 is preferably formed from a composition comprising a silicon-containing polymer. The composition may further include other constituents such as, but not limited to, solvent(s), a catalyst, a stabilizer, and water as detailed below.

The composition may be prepared prior to forming the layer of top coat material 40 or the composition may be formed during at least a portion of the forming process.

In preferred embodiments of the invention, the silicon-containing polymer is preferably formed by sol-gel processing of at least one silica source (also referred to herein as a silica precursor) that will ultimately be reacted to form the silicon-containing polymer. A "silica source", as used herein, is a compound having silicon (Si) and oxygen (O) and possibly additional substituents such as, but not limited to, other elements such as H, B, C, P, or halide atoms and

organic groups such as alkyl groups or aryl groups. The term "alkyl" as used herein includes linear, branched, or cyclic alkyl groups, containing from 1 to 24 carbon atoms, preferably from 1 to 12 carbon atoms, and more preferably from 1 to 5 carbon atoms. This term applies also to alkyl moieties contained in other groups such as haloalkyl, alkylaryl, or arylalkyl. The term "alkyl" further applies to alkyl moieties that are substituted, for example with carbonyl functionality. The term "aryl" as used herein six to twelve member carbon rings having aromatic character. The term "aryl" also applies to aryl moieties that are substituted. The silica source may include materials that have a high number of Si-O bonds, but can further include Si-O-Si bridges, Si-R-Si bridges, Si-C bonds, Si-H bonds, Si-F bonds, or C-H bonds. Preferably, the silica source includes materials that have at least one Si-H bond.

The following are non-limiting examples of silica sources suitable for use in the depolymerizable top coat material 40 of the present invention and method of the present invention. In the chemical formulas which follow and in all chemical formulas throughout this document, the term "independently" should be understood to denote that the subject R group is not only independently selected relative to other R groups bearing different superscripts, but is also independently selected relative to any additional species of the same R group. For example, in the formula $R_aSi(OR^1)_{4-a}Si$, when a is 2, the two R groups need not be identical to each other or to $R^1$. In addition, in the following formulas, the term "monovalent organic group" relates to an organic group bonded to an element of interest, such as Si or O, through a single C bond, *i.e.*, Si-C or O-C. Examples of monovalent organic groups include an alkyl group, an aryl group, an unsaturated alkyl group, and/or an unsaturated alkyl group substituted with alkoxy, ester, acid, carbonyl, or alkyl carbonyl functionality. The alkyl group may be a linear, branched, or cyclic alkyl group having from 1 to 5 carbon atoms such as, for example, a methyl, ethyl, propyl, butyl, or pentyl group. Examples of aryl groups suitable as the monovalent organic group include phenyl, methylphenyl, ethylphenyl and fluorophenyl. In certain embodiments, one or more hydrogens within the alkyl group may be substituted with an additional atom such as a halide atom (*i.e.*, fluorine), or an oxygen atom to give a carbonyl or ether functionality.

In certain preferred embodiments, the silica source may be represented by the following formula: $R_aSi(OR^1)_{4-a}$, wherein R independently represents a hydrogen atom, a fluorine atom, a fluoroalkyl group, a perfluoroalkyl group, or a monovalent organic group; $R^1$ independently represents a monovalent organic group; and a is an integer ranging from 1 to 3. Specific examples of the compounds represented by $R_aSi(OR^1)_{4-a}$ include: methyltrimethoxysilane, methyltriethoxysilane, methyltri-n-propoxysilane, methyltri-iso-propoxysilane, methyltri-n-butoxysilane, methyltri-sec-butoxysilane, methyltri-tert-butoxysilane, methyltriphenoxysilane, ethyltrimethoxysilane, ethyltriethoxysilane, ethyltri-n-propoxysilane, ethyltri-iso-propoxysilane, ethyltri-n-butoxysilane, ethyltri-sec-butoxysilane, ethyltri-tert-butoxysilane, ethyltriphenoxysilane, n-propyltrimethoxysilane, n-propyltriethoxysilane, n-propyltri-n- propoxysilane, n-propyltri-iso-propoxysilane, n-propyltin-n-butoxysilane, n-propyltri-sec-butoxysilane, n-propyltri-tert-butoxysilane, n-propyltriphenoxysilane, isopropyltrimethoxysilane, isopropyltriethoxysilane, isopropyltri-n-propoxysilane, isopropyltriisopropoxysilane, isopropyltri-n-butoxysilane, isopropyltri-sec-butoxysilane, isopropyltri-tert-butoxysilane, isopropyltriphenoxysilane, n-butyltrimethoxysilane, n-butyltriethoxysilane, n-butyltri-n-propoxysilane, n-butyltriisopropoxysilane, n-butyltri-n-butoxysilane, n-butyltri-sec-butoxysilane, n-butyltri-tert-butoxysilane, n-butyltriphenoxysilane; sec-butyltrimethoxysilane, sec-butyltriethoxysilane, sec-butyltri-n-propoxysilane, sec-butyltriisopropoxysilane, sec-butyltri-n-butoxysilane, sec-butyltri-sec-butoxysilane, sec-butyltri-tert-butoxysilane, sec-butyltriphenoxysilane, tert-butyltrimethoxysilane, tert-butyltriethoxysilane, tert-butyltri-n-propoxysilane, tert-butyltriisopropoxysilane, tert-butyltri-n-butoxysilane, tert-butyltri-sec-butoxysilane, tert-butyltri-tert-butoxysilane, tert-butyltriphenoxysilane, isobutyltrimethoxysilane, isobutyltriethoxysilane, isobutyltri-n-propoxysilane, isobutyltriisopropoxysilane, isobutyltri-n-butoxysilane, isobutyltri-sec-butoxysilane, isobutyltri-tert-butoxysilane, isobutyltriphenoxysilane, n-pentyltrimethoxysilane, n-pentyltriethoxysilane, n-pentyltri-n-propoxysilane, n-pentyltriisopropoxysilane, n-pentyltri-n-butoxysilane, n-pentyltri-sec-butoxysilane, n-pentyltri-tert-butoxysilane, n-pentyltriphenoxysilane; sec-pentyltrimethoxysilane, sec-pentyltriethoxysilane, sec-pentyltri-n-propoxysilane, sec-pentyltriisopropoxysilane, sec-pentyltri-n-butoxysilane, sec-pentyltri-sec-butoxysilane, sec-pentyltri-tert-butoxysilane, sec-pentyltriphenoxysilane, tert-pentyltrimethoxysilane, tert-pentyltriethoxysilane, tert-pentyltri-n-propoxysilane, tert-pentyltriisopropoxysilane, tert-pentyltri-n-butoxysilane, tert-pentyltri-sec-butoxysilane, tert-pentyltri-tert-butoxysilane, tert-pentyltriphenoxysilane, isopentyltrimethoxysilane, isopentyltriethoxysilane, isopentyltri-n-propoxysilane, isopentyltriisopropoxysilane, isopentyltri-n-butoxysilane, isopentyltri-sec-butoxysilane, isopentyltri-tert-butoxysilane, isopentyltriphenoxysilane, neo-pentyltrimethoxysilane, neo-pentyltriethoxysilane, neo-pentyltri-n-propoxysilane, neo-pentyltriisopropoxysilane, neo-pentyltri-n-butoxysilane, neo-pentyltri-sec-butoxysilane, neo-pentyltri-neo-butoxysilane, neo-pentyltriphenoxysilane phenyltrimethoxysilane, phenyltriethoxysilane, phenyltri-n-propoxysilane, phenyltriisopropoxysilane, phenyltri-n-butoxysilane, phenyltri-sec-butoxysilane, phenyltri-tert-butoxysilane, phenyltriphenoxysilane, δ-trifluoropropyltrimethoxysilane, δ-trifluoropropyltriethoxysilane, dimethyldimethoxysilane, dimethyldiethoxysilane, dimethyldi-n-propoxysilane, dimethyldiisopropoxysilane, dimethyldi-n-butoxysilane, dimethyldi-sec-butoxysilane, dimethyldi-tert-butoxysilane, dimethyldiphenoxysilane, diethyldimethoxysilane, diethyldiethoxysilane, diethyldi-n-propoxysilane, diethyldiisopropoxysilane, diethyldi-n-butoxysilane, diethyldi-sec-butoxysilane, diethyldi-tert-butoxysilane, diethyldiphenoxysilane, di-n-propyldimethoxysilane, di-n-propyldimethoxysilane, di-n-propyldi-n-propoxysilane, di-n-propyldiisopropoxysilane, di-n-propyldi-n-butoxysilane, di-n-propyldi-sec-butoxysilane, din-propyldi-tert-butoxysilane, di-n-propyldiphenoxysilane, diisopropyldimethoxysilane, diisopropyldiethoxysilane, diisopropyldi-n-propoxysilane, diisopropyldiisopropoxysilane, diisopropyldi-n-butoxysilane, diisopropyldi-sec-butoxysilane, diisopropyldi-tert-butoxysilane, diisopropyldiphenoxysilane, di-n-butyldimethoxysilane, di-n-butyldiethoxysilane, di-n-butyldi-n-propoxysilane, di-n- butyldiisopropoxysilane, di-n-butyldi-n-butoxysilane, di-n-butyldi-sec-butoxysilane, di-n-butyldi-tert-butoxysilane, di-n-butyldiphenoxysilane, di-sec-butyldimethoxysilane, di-sec-butyldiethoxysilane, di-sec-butyldi-n-propoxysilane, di-sec-butyldiisopropoxysilane, di-sec-butyldi-n-butoxysilane, di-sec-butyldi-sec-butoxysilane, di-sec-butyldi-tert-butoxysilane, di-sec-butyldiphenoxysilane, di-tert-butyldimethoxysilane, di-tert-butyldiethoxysilane, di-tert-butyldi-n-propoxysilane, di-tert-butyldiisopropoxysilane, di-tert-butyldi-n-butoxysilane, di-tert-butyldi-sec-butoxysilane, di-tert-butyldi-tert-butoxysilane, di-tert-butyldiphenoxysilane, diphenyldimethoxysilane, diphenyldiethoxysilane, diphenyldi-n-propoxysilane, diphenyldiisopropoxysilane, diphenyldi-n-butoxysilane, diphenyldi-sec-butoxysilane, diphenyldi-tert-butoxysilane, diphenyldiphenoxysilane, methylneopentyldimethoxysilane, methylneopentyldiethoxysilane, methyldimethoxysilane, ethyldimethoxysilane, n-propyldimethoxysilane, isopropyldimethoxysilane, n-butyldimethoxysilane, sec-butyldimethoxysilane, tert-butyldimethoxysilane, isobutyldimethoxysilane, n-pentyldimethoxysilane, sec-pentyldimethoxysilane, tert-pentyldimethoxysilane, isopentyldimethoxysilane, neopentyldimethoxysilane, neohexyldimethoxysilane, cyclohexyldimethoxysilane, phenyldimethoxysilane, methyldiethoxysilane, ethyldiethoxysilane, n-propyldiethoxysilane, isopropyldiethoxysilane, n-butyldiethoxysilane, sec-butyldiethoxysilane, tert-butyldiethoxysilane, isobutyldiethoxysilane, n-pentyldiethoxysilane, sec-pentyldiethoxysilane, tert-pentyldiethoxysilane, isopentyldiethoxysilane, neopentyldiethoxysilane, neohexyldiethoxysilane, cyclohexyldiethoxysilane, phenyldiethoxysilane, trimethoxysilane, triethoxysilane, tri-n-propoxysilane, triisopropoxysilane, tri-n-butoxysilane, tri-sec-butoxysilane, tri-tert-butoxysilane, triphenoxysilane, allyltrimethoxysilane, allyltriethoxysilane, vinyltrimethoxsilane, vinyltriethoxysilane, (3-acryloxypropyl)trimethoxysilane, allyltrimethoxysilane, allyltriethoxysilane, vinyltrimethoxsilane, vinyltriethoxysilane, and (3-acryloxypropyl)trimethoxysilane. In preferred embodiments, the silica source of the formula $R_aSi(OR^1)_{4-a}$ includes at least one the compounds selected from the group consisting of methyltrimethoxysilane, methyltriethoxysilane, methyltri-n-propoxysilane, methyltriisopropoxysilane, ethyltrimethoxysilane, ethyltriethoxysilane, dimethyldimethoxysilane, dimethyldiethoxysilane, diethyldimethoxysilane, diethyldiethoxysilane, trimethoxysilane, triethoxysilane, tri-n-propoxysilane, triisopropoxysilane, tri-n-butoxysilane, tri-sec-butoxysilane, tri-tert-butoxysilane, triphenoxysilane, 3,3,3-trifluoropropyltrimethoxysilane, pentafluorophenyltriethoxysilane, pentafluorophenylpropyltrimethoxysilane, (tridecafluoro-1,1,2,2-tetrahydrooctyl)-triethoxysilane, (tridecafluoro-1,1,2,2-tetrahydrooctyl)trimethoxysilane, 1H,1H,2H,2H-perfluorodecyltriethoxysilane, nonafluorohexyltrimethoxysilane, heptadecafluoro-1,1,2,2-tetrahydrodecyl)trimethoxysilane, and (heptadecafluoro-1,1,2,2-tetrahydrodecyl)triethoxysilane.

Particularly preferred silica sources of the formula $R_aSi(OR^1)_{4-a}$, are those wherein R is a hydrogen atom. Examples of such particularly preferred silica sources include trimethoxysilane and triethoxysilane.

The silica source may also be a compound having the formula $Si(OR^2)_4$ wherein $R^2$ independently represents a monovalent organic group. Specific examples of the compounds represented by $Si(OR^2)_4$ include tetramethoxysilane, tetraethoxysilane, tetra-n-propoxysilane, tetraisopropoxysilane, tetra-n-butoxysilane, tetra-sec-butoxysilane, tetra- tert-butoxysilane, tetraacetoxysilane, and tetraphenoxysilane. Of the above, certain preferred compounds may include tetramethoxysilane, tetraethoxysilane, tetra-n-propoxysilane, tetraisopropoxysilane, or tetraphenoxysilane.

The silica source may also be a compound having the formula $R^3_b(R^4O)_{3-b}Si-(R^7)-Si(OR^5)_{3-c}R^6_c$, wherein $R^3$ and $R^6$ are independently a hydrogen atom, a fluorine atom, or a monovalent organic group; $R^4$ and $R^5$ are independently a monovalent organic group; b and c may be the same or different and each is a number ranging from 0 to 2; $R^7$ is an oxygen atom, a phenylene group, a biphenyl, a naphthalene group, or a group represented by $-(CH_2)_n-$, wherein n is an integer ranging from 1 to 6; or combinations thereof. Specific examples of these compounds wherein $R^7$ is an oxygen atom include: hexamethoxydisiloxane, hexaethoxydisiloxane, hexaphenoxydisiloxane, 1,1,1,3,3-pentamethoxy-3- methyldisiloxane, 1,1,1,3,3-pentaethoxy-3-methyldisiloxane, 1,1,1,3,3-pentamethoxy-3-phenyldisiloxane, 1,1,1,3,3-pentaethoxy-3-phenyldisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,1,3,3-tetraethoxy-1,3-diphenyldisiloxane, 1,1,3-trimethoxy-1,3,3-trimethyldisiloxane, 1,1,3-triethoxy-1,3,3-trimethyldisiloxane, 1,1,3-trimethoxy-1,3,3-triphenyldisiloxane, 1,1,3-triethoxy-1,3,3-triphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane and 1,3-diethoxy-1,1,3,3-tetraphenyldisiloxane. Of those, preferred compounds are hexamethoxydisiloxane, hexaethoxydisiloxane, hexaphenoxydisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyidisiloxane; 1,3-diethoxy-1,1,3,3-tetraphenyldisiloxane. Specific examples of these compounds wherein $R^7$ is a group represented by $-(CH_2)_n-$include: bis(trimethoxysilyl)methane, bis(triethoxysilyl)methane, bis(triphenoxysilyl)methane, bis(dimethoxymethylsilyl)methane, bis(diethoxymethylsilyl)methane, bis(dimethoxyphenylsilyl)methane, bis(diethoxyphenylsilyl) methane, bis(methoxydimethylsilyl)methane, bis(ethoxydimethylsilyl)methane, bis(methoxydiphenylsilyl)methane, bis (ethoxydiphenylsilyl)methane, 1,2-bis(trimethoxysilyl)ethane, 1,2-bis(triethoxysilyl)ethane, 1,2-bis(triphenoxysilyl) ethane, 1,2-bis(dimethoxymethylsilyl)ethane, 1,2-bis(diethoxymethylsilyl)ethane, 1,2-bis(dimethoxyphenylsilyl)ethane, 1,2-bis(diethoxyphenylsilyl)ethane, 1,2-bis(methoxydimethylsilyl)ethane, 1,2-bis(ethoxydimethylsilyl)ethane, 1,2-bis(methoxydiphenylsilyl)ethane, 1,2-bis(ethoxydiphenylsilyl)ethane, 1,3-bis(trimethoxysilyl)propane, 1,3-bis(triethoxysilyl) propane, 1,3-bis(triphenoxysilyl)propane, 1,3-bis(dimethoxymethylsilyl)propane, 1,3-bis(diethoxymethylsilyl)propane, 1,3-bis(dimethoxyphenylsilyl)propane, 1,3-bis(diethoxyphenylsilyl)propane, 1,3-bis(methoxydimethylsilyl)propane, 1,3-bis(ethoxydimethylsilyl)propane, 1,3-bis(methoxydiphenylsilyl)propane, and 1,3-bis(ethoxydiphenylsilyl) propane. Of those, preferred compounds are bis(trimethoxysilyl)methane, bis(triethoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethylsilyl)methane, bis(methoxydiphenylsilyl)methane and bis(ethoxydiphenylsilyl)methane.

In certain preferred embodiments of the present invention, $R^1$ of the formula $R_aSi(OR^1)_{4-a}$; $R^2$ of the formula $Si(OR^2)_4$; and $R^4$ and/or $R^5$ of the formula $R^3_b(R^4O)_{3-b}Si-(R^7)-Si(OR^5)_{3-c}R^6_c$ can each independently be a monovalent organic group of the formula:

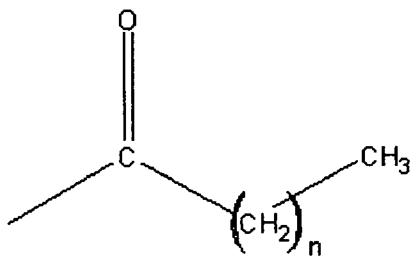

wherein n is an integer from 0 to 4. Specific examples of these compounds include: tetraacetoxysilane, methyltriacetoxysilane, ethyltriacetoxysilane, n-propyltriacetoxysilane, isopropyltriacetoxysilane, n-butyltriacetoxysilane, sec-butyltriacetoxysilane, tert-butyltriacetoxysilane, isobutyltriacetoxysilane, n-pentyltriacetoxysilane, sec-pentyltriacetoxysilane, tert-pentyltriacetoxysilane, isopentyltriacetoxysilane, neopentyltriacetoxysilane, phenyltriacetoxysilane, dimethyldiacetoxysilane, diethyldiacetoxysilane, di-n-propyldiacetoxysilane, diisopropyldiacetoxysilane, di-n-butyldiacetoxysilane, di-sec-butyldiacetoxysilane, di-tert-butyldiacetoxysilane, diphenyldiacetoxysilane, triacetoxysilane. Of these compounds, tetraacetoxysilane and methyltriacetoxysilane are preferred.

In embodiments of the present invention where it is preferred that top coat 40 is more hydrophobic, the silica source comprises at least one fluoroalkyl group, perfluoroalkyl group, or pentafluorosulfuranyl group (collectively referred to herein as a "fluorinated silica source"). The amount of fluorinated silica source preferably ranges from about 0.01 to about 100 wt%, more preferably from about 0.01 to about 50 wt% and, most preferably, from about 0.01 to about 20 wt% of the composition employed to form top coat material 40. Preferably, the at least one fluoroalkyl group, perfluoroalkyl group, or pentafluorosulfuranyl group includes linear, branched or cyclic groups, containing 1-24 carbon atoms, with at least one atom being fully substituted by F. The fluorine-substitution functions to increase the film's hydrophobicity without absorbing additional UV light of the desired wavelength This increase in hydrophobicity may contribute to the prevention of the formation of water droplets and, hence, significantly reduce the occurrence of water-mark defects on the substrate. One of ordinary skill in the art will understand that the hydrophobicity can be adjusted by controlling the amount of fluorine atoms in the silica source. Examples of such fluorinated silica sources include 3,3,3-trifluoropropyltrimethoxysilane, pentafluorophenyltriethoxysilane, pentafluorophenylpropyltrimethoxysilane, (tridecafluoro-1,1,2,2-tetrahydrooctyl)-triethoxysilane, (tridecafluoro-1,1,2,2-tetrahydrooctyl)trimethoxysilane, 1H,1H,2H,2H-perfluorodecyltriethoxysilane, nonafluorohexyltrimethoxysilane, heptadecafluoro-1,1,2,2-tetrahydrodecyl)trimethoxysilane, (heptadecafluoro-1,1,2,2-tetrahydrodecyl)triethoxysilane, 1-pentafluorosulfuranyl-3-triethoxysilylmethane, 1-pentafluorosulfuranyl-3-triethoxysilylethane, 1-pentafluorosulfuranyl-3-triethoxysilylpropane, 1-pentafluorosulfuranyl-4-triethoxysilylbutane, 1-pentafluorosulfuranyl-5-triethoxysilylpentane, 1-pentafluorosulfuranyl-6-triethoxysilylhexane, 1-pentafluorosulfuranyl-3-trimethoxysilyl-1-propene, 1-pentafluorosulfuranyl-4-trimethoxysilyl-1-butene, 1-pentafluorosulfuranyl-5-trimethoxysilyl-1-pentene, 1-pentafluorosulfuranyl-6-trimethoxysilyl-1-hexene, (1, 2, 3, 4, 5-pentafluorosulfuranylphenyl)propyl trimethoxysilane, and mixtures thereof. Other fluorinated silica sources for use in accordance with the present invention include those disclosed in U.S. Patent Nos. 7,060,634, 7,062,145, 6,479,645, 7,060,846, 6,870,068, 6,958,415, the disclosures of which are incorporated herein by reference in their entirety.

Other examples of the silica source may include a fluorinated silane or fluorinated siloxane such as those provided in U.S. Patent No. 6,258,407, which is incorporated herein by reference.

Another example of the silica source may include compounds that produce a Si-H bond upon elimination.

In other embodiments of the present invention, the silica source may preferably have an at least one carboxylic acid ester bonded to the Si atom. Examples of these silica sources include tetraacetoxysilane, methyltriacetoxysilane, ethyltriacetoxysilane, phenyltriacetoxysilane, triacetoxysilane, methyldiacetoxysilane, dimethylacetoxysilane, trimethylacetoxysilane. In addition to the at least one silica source wherein the silica source has at least one Si atom having a

carboxylate group attached thereto, the composition may further comprise additional silica sources that may not necessarily have the carboxylate attached to the Si atom.

The silica source may also be a linear, cyclic, or branched siloxane, a linear, cyclic, or branched carbosiliane, a linear, cyclic, or branched silazane, a polyhedral oligomeric silsesquioxane, or mixtures thereof.

In other embodiments of the present invention, organosilanes and organosiloxanes are preferred silica sources. Suitable organosilanes and organosiloxanes include, e.g.: (a) alkylsilanes represented by the formula $R^{11}{}_nSiR^{12}{}_{4-n}$, where n is an integer from 1 to 3; $R^{11}$ and $R^{12}$ are independently at least one branched or straight chain $C_1$ to $C_8$ alkyl group (*e.g.*, methyl, ethyl), a $C_3$ to $C_8$ substituted or unsubstituted cycloalkyl group (*e.g.*, cyclobutyl, cyclohexyl), a $C_3$ to $C_{10}$ partially unsaturated alkyl group (*e.g.*, propenyl, butadienyl), a $C_6$ to $C_{12}$ substituted or unsubstituted aromatic (*e.g.*, phenyl, tolyl), and $R^2$ is alternatively hydride (*e.g.*, methylsilane, dimethylsilane, trimethylsilane, tetramethylsilane, phenylsilane, methylphenylsilane, cyclohexylsilane, tert-butylsilane, ethylsilane, diethylsilane, , methyldiethoxysilane, trimethylphenoxysilane and phenoxysilane); (b) a linear organosiloxane represented by the formula $R^{11}(R^{12}{}_2SiO)_nSiR^{12}{}_3$ where n is an integer from 1 to 10, or cyclic organosiloxane represented by the formula $(R^1R^2SiO)_n$ where n is an integer from 2 to 10 and $R^{11}$ and $R^{12}$ are as defined above (e.g., 1,3,5,7-tetramethylcyclotetrasiloxane, octamethylcyclotetrasiloxane, hexamethylcyclotrisiloxane, hexamethyldisiloxane, 1,1,2,2-tetramethyldisiloxane, and octamethyltrisiloxane); and (c) a linear organosilane oligomer represented by the formula $R^{12}(SiR^{11}R^{12})_nR^{12}$ where n is an integer from 2 to 10, or cyclic organosilane represented by the formula $(SiR^1R^2)_n$, where n is an integer from 3 to 10, and $R^{11}$ and $R^{12}$ are as defined above (e.g., 1,2-dimethyldisilane, 1,1,2,2-tetramethyldisilane, 1,2-dimethyl-1,1,2,2-dimethoxydisilane, hexamethyldisilane, octamethyltrisilane, 1,2,3,4,5,6-hexaphenylhexasilane, 1,2-dimethyl-1,2-diphenyldisilane and 1,2-diphenyldisilane). In certain embodiments, the organosilane/organosiloxane is a cyclic alkylsilane, a cyclic alkoxysilane or contains at least one alkoxy or alkyl bridge between a pair of Si atoms, such as 1,2-disilanoethane, 1,3-disilanopropane, dimethylsilacyclobutane, 1,2-bis(trimethylsiloxy)cyclobutene, 1,1-dimethyl-1-sila-2,6-dioxacyclohexane, 1,1-dimethyl-1-sila-2-oxacyclohexane, 1,2-bis(trimethylsiloxy)ethane, 1,4-bis(dimethylsilyl)benzene or 1,3-(dimethylsilyl)cyclobutane. In certain embodiments, the organosilane/organosiloxane contains a reactive side group selected from the group consisting of an epoxide, a carboxylate, an alkyne, a diene, phenyl ethynyl, a strained cyclic group and a $C_4$ to $C_{10}$ group which can sterically hinder or strain the organosilane/organosiloxane, such as trimethylsilylacetylene, 1-(trimethylsilyl)-1,3-butadiene, trimethylsilylcyclopentadiene, trimethylsilylacetate and di-tert-butoxydiacetoxysilane..

The catalyst suitable for the present invention, if employed, includes any organic or inorganic acid or base that can catalyze the hydrolysis of substitutents from the silica source in the presence of water, and/or the condensation of two silica sources to form an Si-O-Si bridge. The catalyst can be an organic base such as, but not limited to, quaternary ammonium salts and hydroxides, such as ammonium or tetramethylammonium, amines such as primary, secondary, and tertiary amines, and amine oxides. In preferred embodimens of the present invention, the catalyst is an inorganic acid such as, but not limited to, nitric acid, hydrochloric acid, and sulfuric acid. In other preferred embodiments, the catalyst is carboxylic acid such as, but not limited to, maleic, oxalic, acetic, formic, glycolic, glyoxalic acid, citric, malic, or mixtures thereof. In yet other preferred embodiments, the catalyst is an amino acid such as, but not limited to, guanine and lysine. In the most preferred embodiments, the catalyst is dilute nitric acid.

In addition to the silicon-containing polymer, the composition from which top coat material 40 is formed preferably includes a stabilizer that functions to stabilize the silicon-containing polymer and inhibit further undesired polymerization. Such stabilizers include 2,4-pentanedione, 1-hexanoic acid, glycerol, acetic anhydride and 1,1,1,5,5,5-hexamethyltrisiloxane. Free radical stabilizers also may be employed in compositions of the present invention where the silicon-containing polymer has the potential to further polymerize by free-radical initiation. Examples of free radical scavengers include 2,6-di-tert-butyl-4-methyl phenol (or BHT for butylhydroxytoluene), 2,2,6,6-tetramethyl-1-piperidinyloxy (TEMPO), 2-tert-butyl-4-hydroxyanisole, 3-tert-butyl-4-hydroxyanisole, propyl ester 3,4,5-trihydroxy-benzoic acid, 2-(1,1-dimethylethyl)-1,4-benzenediol, diphenylpicrylhydrazyl, 4-tert-butylcatechol, N-methylaniline, p-methoxydiphenylamine, diphenylamine, N,N'-diphenyl-p-phenylenediamine, p-hydroxydiphenylamine, phenol, octadecyl-3-(3,5-di-tert-butyl-4-hydroxyphenyl) propionate, tetrakis (methylene (3,5-di-tert-butyl)-4-hydroxy-hydrocinnamate) methane, phenothiazines, alkylamidonoisoureas, thiodiethylene bis (3,5,-di-tert-butyl-4-hydroxy-hydrocinnamate, 1,2,-bis (3,5-di-tert-butyl-4-hydroxyhydrocinnamoyl) hydrazine, tris(2-methyl-4-hydroxy-5-tert-butylphenyl) butane, cyclic neopentanetetrayl bis (octadecyl phosphite), 4,4'-thiobis (6-tert-butyl-m-cresol), 2,2'-methylenebis (6-tert-butyl-p-cresol), oxalyl bis (benzylidenehydrazide) and naturally occurring antioxidants such as raw seed oils, wheat germ oil, tocopherols and gums.

The composition from which top coat material 40 is formed preferably includes a solvent. The term "solvent" as used herein refers to any liquid or supercritical fluid that provides solubility with the other components, adjusts the film thickness, provides sufficient optical clarity for subsequent processing steps, such as lithography, and may be at least partially removed upon curing (i.e., exposure to an energy source such as, for example, heat). Solvents that are suitable for use in the present invention may include any solvent that, for example, exhibits solubility with the reagents/components, affects the viscosity of the mixture, and/or affects the surface tension of the mixture upon deposition onto the substrate. Solvents can be alcohol solvents, ketone solvents, amide solvents, glycol solvents, glycol ether solvents, or ester solvents. In certain embodiments, one or more solvents used in the present invention have relatively low boiling

points, *i.e.*, below 160°C. These solvents include, but are not limited to, ethanol, isomers of propanol, isomers of butanol, and isomers of pentanol. Other solvents, that can be used in the present invention but have boiling points above 160°C, include dimethylformamide, dimethylacetamide, N-methyl pyrrolidone, ethylene carbonate, propylene carbonate, glycerol and derivatives, naphthalene and substituted versions, acetic acid anyhydride, propionic acid and propionic acid anhydride, dimethyl sulfone, benzophenone, diphenyl sulfone, phenol, m-cresol, dimethyl sulfoxide, diphenyl ether, terphenyl, and the like. Preferred solvents include propylene glycol propyl ether (PGPE), 3-heptanol, 2-methyl-1-pentanol, 5-methyl-2-hexanol 3-hexanol, 2-heptanol, 2-hexanol, 2,3-dimethyl-3-pentanol, propylene glycol methyl ether acetate (PGMEA), ethylene glycol n-butyl ether, propylene glycol n-butyl ether (PGBE), 1-butoxy-2-propanol, 2-methyl-3-pentanol, 2-methoxyethyl acetate, 2-butoxyethanol, 2-ethoxyethyl acetoacetate, 1-pentanol, 1-butanol, n-propanol, isopropanol, and propylene glycol methyl ether. Still further exemplary solvents include lactates, pyruvates, and diols. The solvents enumerated above may be used alone or in combination of two or more solvents. In preferred embodiments, the solvent may comprise one or more solvents with relatively low boiling points, *i.e.*, boiling points below 160°C.

The composition optionally comprises water. Water, if present in the composition, may function as a reactant in the hydrolysis of the silica source. Water may also act as a solvent and it may act as a catalyst.

It is preferred that the composition of the present invention from which top coat material 40 is made has a certain acidity level expressed by the pAcid value. The pAcid value provides an estimate of the acidity of the mixture and can be calculated from the amounts of strong acid and strong base in the mixture. For these purposes, a strong acid is defined as having a $pK_a$ of less than 2, and a strong base is defined as having a $pK_a$ of its conjugate acid of greater than 12. Examples of strong acids include $HNO_3$, HCl, both acidic protons of $H_2SO_4$, the stronger acidic proton of maleic acid, the stronger acidic proton of oxalic acid, etc. Examples of strong bases include NaOH, KOH, tetramethylammonium hydroxide (TMAH), etc. When the number of equivalents of strong acid is greater than the number of equivalents of strong base, then the pAcid value of the mixture can be calculated using the following equation (5):

$$\text{pAcid} = -\log[(\text{equivalents of strong acid} - \text{equivalents of strong base})/(\text{kg total mixture})]$$

When the number of equivalents of strong acid is less than the number of equivalents of strong base, then the pAcid value of the mixture can be calculated using the following equation (6):

$$\text{pAcid} = 14 + \log[(\text{equivalents of strong base} - \text{equivalents of strong acid})/(\text{kg total mixture})]$$

When the number of equivalents of strong acid equals the number of equivalents of strong base, then

$$\text{pAcid} = 7$$

A composition according to the present invention having a relatively low acidity level, i.e., having a pAcid value that ranges from about 1 to about 9, typically will provide improved stability at lower pAcids, but catalyzes the depolymerization of the polymer at higher pAcids such as, for example, when top coat material 40 needs to be removed. For example, at a pAcid value of less than 2, the rate of hydrolysis is large compared to the rate of condensation. Since hydrolysis is likely to be nearly completed at early stages in the process, the growing polymer typically grows by reaction of limited cluster-cluster aggregation resulting in weakly branched structures. Because the rate of depolymerization of higher molecular weight species, *i.e.*, siloxane bond hydrolysis, is low, the condensation reactions forming these types of polymers is essentially irreversible. Thus, non-equilibrium structures are kinetically stabilized because bond breakage does not occur and they are unable to re-structure without a source of monomer to fill in any of the defects in the polymer structure. At pAcid values of greater than 7, the hydrolysis of larger polymeric species is nearly complete. De-polymerization occurs at the weakly branched sites resulting in the formation of additional monomers. Since there is a large supply of monomer to the system and there is significant de-polymerization of the network, the typical growth mechanism is a monomer-cluster model. Given that the depolymerization reactions are rate limited the resulting structures are more compact and spherical in nature. Under basic conditions, the rate of de-polymerization of the silicon-containing polymer is significantly faster than the rate of condensation. Hence the exposure of silicon-containing polymermic top coats to an aqueous base-containing solutions (i.e., developer) results in the de-polymerization of the topcoat into soluble species. In this regard, the sol-gel polymer compositions behave as detailed in Sol-Gel Science: The Physics and Chemistry of

Sol-Gel Processing, by C. Jeffrey Brinker and George W. Scherer Academic Press, San Diego, 1990, which is incorporated herein by reference.

In preferred embodiments, the pAcid value ranges from about 1 to 6. In more preferred embodiments, the pAcid value ranges from about 2 to 5. In certain preferred embodiments, the pAcid value may be adjusted to this range by adding a strong acid catalyst, i.e., having a $pK_a$ of less than 2, to the mixture. Although the pAcid value is intended to be an estimate of the pH of the mixture, pAcid values for compositions containing weak acids such as acetic acid, either added to the mixture or generated *in situ* by hydrolysis of the silica source, may be a poor approximation of the actual pH when the amount of weak acid is substantially in excess of the equivalents of strong acid minus the equivalents of strong base.

In certain preferred embodiments of the present invention, the at least one silica source is added to the composition as the product of hydrolysis and condensation. Hydrolysis and condensation of the at least one silica source occurs by adding water and a catalyst to a solvent and adding the at least one silica source at a time, intermittently or continuously, and conducting hydrolysis and condensation reactions while stirring the mixture at a temperature range generally from -30 to 100°C, preferably from 20 to 100°C, for 0 to 24 hours. The composition can be regulated to provide a desired solid content by conducting concentration or dilution with the solvent in each step of the preparation.

Deposition of top coat material 40 in accordance with the present invention may be carried out by any suitable operation known to those skilled in the art, such as, for example, dip-coating or drainage, spin-coating, liquid misted deposition, aerosol spraying, or other liquid-to-solid coating operations.

In preferred embodiments of the present invention, deposition of top coat material 40 is carried out by a spin-coating process. In one embodiment, the silica source is added to the solvent after which the catalyst and water are added to prepare the final composition that is ready for deposition by, for example, spin coat deposition.

In some embodiments of the present invention, the rapid spin-coating motion causes the solvents, *i.e.*, either added or a by-product of hydrolysis and condensation, to be removed, thereby inducing film formation. While not intending to be bound by any particular theory, it is believed that, during this process, the silicon-containing polymer further reacts and is concentrated by evaporation of the fluid component of the sol, leading to the creation of a physical or chemical gel. In these embodiments, the top coat material is ready for use as a top coat. As used herein, the phrase "ready for use as a top coat" means that the material, after the spin coating process, is ready to be used as a top coat in a photolithographic such as, for example, an immersion lithographic process, without the need for additional processing such as, for example, a post-apply bake.

Top coat material 40, however, optionally may be subjected to a post-apply bake to remove any solvent from the top coat composition and improve the coherence of the top coat layer. Typical post-apply baking temperature is preferably from about 25 to about 200°C, more preferably from about 50 to about 200°C, and most preferably from about 80 to about 150°C. Thus, in one embodiment, the present invention provides a top coat for use in a lithographic process prepared by: applying a layer of a composition adjacent to a layer of photoresist, the composition comprising a silicon-containing polymer prepared by sol-gel processing at least one silica source, wherein the layer is ready for use as a top coat; and optionally subjecting the layer of top coat material to a temperature of from about 50 to about 200°C, wherein the silicon-containing polymer in the top coat material depolymerizes upon exposure to an aqueous base-containing solution.

FIGS. 2 and 3 illustrate how an article 10 of the present invention functions to reduce nano-bubble defects. In FIG. 2, the article 10 is a standard article comprising the elements of FIG. 1 (without the top coat material 40) that is covered, at least in part, with immersion liquid (not shown) during imaging. As illustrated in FIG. 2, bubbles and/or particles 25 in the immersion liquid are only 80 nm away (*i.e.*, the thickness of the protective layer 30) from the radiation sensitive layer 20. In this instance, any bubbles and/or particles on the surface of the substrate can seriously affect the imaging quality, for example, by being within the depth of focus. In contrast, as can be seen from FIG. 3, top coat material 40 keeps any bubbles and/or particles in the immersion liquid at least a distance "t" from the radiation sensitive layer 20. Thus, the effect of the bubbles and/or particles on the imaging quality can be considerably reduced (for example, by having the bubbles and/or particles out of focus) without making the lithographic projection apparatus any more complex. In an embodiment, top coat material 40 is hydrophilic, e.g., with a contact angle in the range of from 50 to 70 degrees, to inhibit bubble forming as well as helping any bubbles that do form out of focus.

In preferred embodiments of the present invention, top coat material 40 is hydrophobic, *i.e.*, having a contact angle greater than 70 degrees. In such embodiments, the occurrence of certain defects such as, for example, water spots are significantly reduced due to the more efficient removal of water from the substrate as a result of its increased hydrophobic nature.

In certain embodiments of the present invention, it is desired that the top coat material 40 has a refractive index substantially the same as that of the immersion liquid, perhaps within 0.2 or 0.1 of that of the immersion liquid. In this way, optical effects such as those resulting from variations in thickness of top coat material 40 can be ignored. Thus, in an embodiment, top coat material 40 has a refractive index greater than that of air. In another embodiment, top coat material 40 has a refractive index that is as much as that of the immersion liquid if not more. In yet another embodiment,

top coat material 40 has a refractive index in the range of 1 to 1.9.

In certain embodiments of the present invention, top coat material 40 is much thicker than the wavelength of the projection beam. A thickness to bubble and/or particle diameter ratio should be as close as possible to or larger than 10 to 1. The maximum expected bubble and/or particle size is 1 μm so for best performance the thickness of the top coating 24 should be at least 10 μm. In an embodiment, the thickness may be at least 20 μm or at least 30 μm and up to 100 μm above which the coating may become harder to provide and cost prohibitive.

In another aspect of the invention, top coat material 40 may be used in a method of forming a pattern on material layer 15. Material layer 15 may be, for example, a ceramic, dielectric, metal or semiconductor layer, such as those used in the manufacture of high performance integrated circuit devices and associated chip carrier packages. In the method, a photoresist composition is first deposited on the material layer by known means, to form a photoresist layer 20 on the material layer 15. The material layer with the resist layer then may be baked (post-apply bake) to remove any solvent from the photoresist composition and improve the coherence of the resist layer. In a typical post-apply bake, the layer is subjected to a temperature of from about 80 to about 150°C. Typical resist thickness is about 100 to about 500 nm. Any suitable resist composition may be used.

Any suitable energy source may be used for the post-apply bake. Exemplary energy sources may include, but not be limited to, an ionizing radiation source such as α-particles, β-particles, γ-rays, x-rays, electron beam sources of energy; a nonionizing radiation source such as ultraviolet (10 to 400 nm), visible (400 to 750 nm), infrared (750 to $10^5$ nm), microwave (> $10^6$), and radio-frequency (> $10^6$) wavelengths of energy; or compositions thereof. Still further energy sources include thermal energy and plasma energy. Depending upon the energy source, the exposure step can be conducted under high pressure, atmospheric, or under a vacuum. The environment can be inert (e.g., nitrogen, $CO_2$, noble gases (He, Ar, Ne, Kr, Xe), etc.), oxidizing (*e.g.*, oxygen, air, dilute oxygen environments, enriched oxygen environments, ozone, nitrous oxide, etc.) or reducing (dilute or concentrated hydrogen, hydrocarbons (saturated, unsaturated, linear or branched, aromatics), etc.). The pressure is preferably about 1 Torr to about 1000 Torr, more preferably atmospheric pressure. In other embodiments, vacuum to ambient pressures are possible for thermal energy sources as well as any other exposure means.

Next, top coat material 40 according to the present invention is applied adjacent to the photoresist layer, thereby forming a coated substrate. As used in this connection, the term "adjacent to" includes embodiments such as, for example, that detailed in FIGS. 1 to 3 wherein a protective material is on top of the photoresist layer. Thus, the top coat is "adjacent to" the layer of photoresist even though there is at least one other layer between the top coat and the photoresist. The substrate with the top coat layer is optionally subjected to another post-apply bake to remove any solvent from the top coat composition and improve the coherence of the top coat layer. Typical post-apply baking temperature is preferably from about 25 to about 200°C, more preferably from about 50 to about 200°C, and most preferably from about 80 to about 150°C.

In other preferred embodiments of the present invention, the photoresist composition is deposited on the material layer to form a photoresist layer 20 on the material layer 15 and, without a post-apply bake, topcoat material 40 is applied and the composite comprising the photoresist layer 20 and the top coat material 40 is subjected to a post-apply bake.

The coated article is then exposed to an appropriate irradiation source, through a patterned mask. In one exemplary embodiment, the imaging radiation is 193 nm radiation. In another embodiment, the imaging radiation is 157 nm radiation. In another embodiment, the imaging radiation is 248 nm radiation. The coated article also may be exposed to such imaging radiation using immersion lithography, wherein an imaging medium is applied to the coated article prior to exposure. Any suitable imaging medium may be used in accordance with the present invention.

The next step is optionally a post-exposure bake to insure that all of the solvent and any gaseous by-products of the exposure to light are removed. During the post-exposure bake, the photoresist and topcoat may be subjected to one or more energy sources to cure and/or partially cure the photoresist and/or top coat. Exemplary energy sources may include, but not be limited to, an ionizing radiation source such as α-particles, β-particles, γ-rays, x-rays, electron beam sources of energy; a nonionizing radiation source such as ultraviolet (10 to 400 nm), visible (400 to 750 nm), infrared (750 to $10^5$ nm), microwave (> $10^6$), and radio-frequency (> $10^6$) wavelengths of energy; or compositions thereof. Still further energy sources include thermal energy and plasma energy. Depending upon the energy source, the exposure step can be conducted under high pressure, atmospheric, or under a vacuum. The environment can be inert (e.g., nitrogen, $CO_2$, noble gases (He, Ar, Ne, Kr, Xe), etc.), oxidizing (*e.g.*, oxygen, air, dilute oxygen environments, enriched oxygen environments, ozone, nitrous oxide, etc.) or reducing (dilute or concentrated hydrogen, hydrocarbons (saturated, unsaturated, linear or branched, aromatics), etc.). The pressure is preferably about 1 Torr to about 1000 Torr, more preferably atmospheric pressure. In other embodiments, vacuum to ambient pressures are possible for thermal energy sources as well as any other exposure means. The temperature for the exposure step may range from 25°C to 300°C. In certain embodiments, the temperature may be ramped at a rate is from 0.1 to 100 deg °C/min. The total treatment time is preferably from 0.01 min to 12 hours. In preferred embodiments, the exposure is conducted under an inert purge at atmospheric conditions using thermal energy at temperatures between 25 and 200°C.

The coated article is then contacted with an aqueous base-containing developer, such as tetramethyl ammonium hydroxide, potassium hydroxide, sodium hydroxide, or other base, thereby removing the top coat material by depolymerization and removal of a portion of the photoresist layer simultaneously from the coated article. Contact with developer forms a patterned photoresist layer on the material layer. Further examples of basic, i.e., alkaline-containing, developer solutions include those provided in U.S. Pat. Nos. 6,455,234; 6,268,115; 6,238,849; 6,127,101; and 6,120,978.

The pattern in the photoresist layer then may be transferred to the material layer on the underlying substrate. Typically, the transfer is achieved by reactive ion etching or some other etching technique. The method of the invention may be used to create patterned material layer structures such as metal wiring lines, holes for contacts or vias, insulation sections (e.g., damascene trenches or shallow trench isolation), trenches for capacitor structures, etc. as might be used in the design of integrated circuit devices.

The following non-limiting examples are provided to further illustrate the present invention. Because these examples are provided for illustrative purposes only, the invention embodied therein should not be limited thereto.

## EXAMPLES

### Example 1

13.5g of propylene glycol propyl ether (PGPE or 1-proxy-2-propanol) was added to 0.96g of Gelest Triethoxysilane (HTES). The mixture was shaken briefly. 0.06g of an acid/base solution containing 96% 0.1 M nitric acid and 4% 0.26M tetramethylammonium hydroxide (TMAH) aqueous solutions were then added and the solution was shaken briefly to mix. The pAcid of the solution was calculated to be:

| g silica | g solvent | G acid | g base | kg total | [H+] | [OH-] | pAcid |
|---|---|---|---|---|---|---|---|
| 0.96 | 13.5 | 0.0576 | 0.0024 | 0.01452 | 0.00000576 | 0.000000624 | 3.45 |

Bottom film for top coat: TARF-P6111 photoresist was spun onto a 100 mm P-type 1-0-0 high resistivity Si wafer. Spinning conditions: 25 sec. at 3500 RPM, solution charge-2 ml. The wafer was calcined at 135°C for 1 min.

The HTES solution was ambient aged for 6 days then spun onto the photoresist film. 1.2 ml of the solution was applied to the wafer during the dispense segment, 7 sec. at 500 RPM. After dispense, the wafer was spun for 40 sec. at 1800 RPM. The wafer was calcined at 135°C for 1 min. on a hot plate.

The wafer was then placed on the spinner chuck. 1 ml of Optiyield™ photoresist developer was puddled in the center of the wafer. Optiyield™ photoresist developer is commercially available from Air Products and Chemicals, Inc., Allentown, Pennsylvania. After 1 minute, the developer was spun off (7 sec. at 500 RPM then 40 sec. at 1800 RPM). During the 1800 RPM segment, the wafer was sprayed with a small amount of deionized water.

Table 1 shows that, with a silane precursor, the silicon-containing polymer is soluble in aqueous base mixtures.

**Table 1:**

| **Resist Layer** | | **Top Coat** | | **Top Coat Layer (after developing)** |
|---|---|---|---|---|
| Thickness (nm) | Refractive Index | Thickness (nm) | Porosity | Thickness (nm) |
| 206.2 | 1.5262 | 46.71 | 3.3 | 0 |

### Examples 2 and 3

PGPE solution: 0.96g of Aldrich triethoxysilane (HTES) was placed in a 1 oz. polyethylene bottle. 13.5g of Schumacher propylene glycol propyl ether (PGPE or 1-proxy-2-propanol) was added and the mixture was shaken briefly. 0.30g 0.01M maleic acid solution was added and the mixture was again shaken briefly to mix.

1-Pentanol solution: 0.96g of Aldrich triethoxysilane (HTES) was placed in a 1 oz. polyethylene bottle. 13.5g of distilled 1-pentanol was added and the mixture was shaken briefly. 0.30g of 0.01 M maleic acid solution was added. The mixture was again shaken briefly to mix. The pAcid of both solutions was calculated to be:

| g silica | g solvent | G acid | g base | kg total | [H+] | [OH-] | **pAcid** |
|---|---|---|---|---|---|---|---|
| 0.96 | 13.5 | 0.3 | 0 | 0.01476 | 0.000003 | 0 | **3.69** |

Bottom film for top coat: TARF-P6111 photoresist was spun onto a 100 mm P type 1-0-0 high resistivity Si wafer. Spinning conditions: 25 sec. at 3500 RPM, solution charge-2 ml. The wafer was calcined at 135°C for 1 min.

The HTES solutions were ambient aged for 2 days then spun onto a photoresist film. 1.2 ml of the solution was applied to the wafer during the spin (7 sec. at 500 RPM). After dispense, the wafer was spun for 35 sec. at 1500 RPM. The wafer was calcined at 135°C for 1 min. on a hot plate.

The wafers were then placed on the spinner chuck. 5 ml of Optiyield™ photoresist developer was puddled in the center of each wafer. After 1 min. the developer was spun off (35 sec. at 3500 RPM). During the spin, the wafer was sprayed with a small amount of deionized water.

From the results listed in Table 2, it can be seen that changing solvents does not affect solubility of the coating in aqueous base mixtures. Changing solvent, however, may have other effects such as, for example, solubilization at the interface of the resist. Hence, solvents with low resist solubility should be better suited for use in the top coat composition according to the present invention.

**Table 2:**

| **Solvent** | **Photoresist** | | | **Top coat** | | **Top Coat After Contact with Developer** | |
|---|---|---|---|---|---|---|---|
| | Thickness (um) | | | Thickness (um) | | Thickness (um) | |
| | | | | | | | |
| PGPE | 0.2527 | | | 0.0354 | | 0 | |
| | 0.2526 | | | 0.0356 | | 0 | |
| | 0.2526 | | | 0.0353 | | 0 | |
| Average | **0.2526** | | Average | **0.035433** | | | |
| | | | | | | | |
| 1-PenOH | 0.2544 | | | 0.0317 | | 0 | |
| | 0.2541 | | | 0.0313 | | 0 | |
| | 0.255 | | | 0.0298 | | 0 | |
| Average | **0.2545** | | Average | **0.030933** | | | |

Example 4

13.5g of Schumacher propylene glycol propyl ether (PGPE or 1-proxy-2-propanol) was added to 0.96g of Gelest triethoxysilane (HTES). The mixture was shaken briefly. 0.30g of deionized water was added and the solution was shaken briefly to mix. The pAcid of Example 4 was assumed to be 7.0 because no acid was added.

The bottle was then placed in a 50°C water bath for approximately 11 hours.

Bottom film for top coat: TARF-P6111 photoresist was spun onto a 100mm P type 1-0-0 high resistivity Si wafer. Spinning conditions: 25 sec. at 3500 RPM, solution charge-2 ml. The wafer was calcined at 135°C for 1 min.

The HTES solution was ambient aged for 2 days then spun onto the photoresist film. 1.2 ml of the solution was applied to the wafer at the beginning of a 25 sec. at 3500 RPM spin. The wafer was then calcined at 135°C for 1 min. on a hot plate.

The wafer was then placed on the spinner chuck. 1 ml of Optiyield™ photoresist developer was puddled in the center of the wafer. After 1 min., the developer was spun off (7 sec. at 500 RPM, then 40 sec. at 1800 RPM). During the 1800 RPM segment, the wafer was sprayed with a small amount of deionized water.

From the results depicted in Table 3, it can be seen that the presence of a catalyst is not necessary for the function of the top coat.

**Table 3:**

| **Photo resist layer** | | **Top coat** | **Top coat (after developer)** | |
|---|---|---|---|---|
| Thickness (nm) | Refractive Index | Thickness (nm) | Thickness (nm) | Error |
| 200.07 | 1.5267 | 50.87 | 0.04 | 0.25 |

Example 5

27.0g Schumacher propylene glycol propyl ether (PGPE or 1-proxy-2-propanol) was added to 1.92g of Aldrich Triethoxysilane (HTES). The solution was briefly shaken. 0.06g of 0.05M citric acid solution was added and shaken to mix. Next, 0.24g of deionized water was added and the solution was shaken to mix. The pAcid of the solution was calculated to be:

| g silica | g solvent | g acid | G base | g water | kg total | [H+] | [OH-] | **pAcid** |
|---|---|---|---|---|---|---|---|---|
| 1.92 | 27 | 0.06 | 0 | 0 | 0.02898 | 0.000003 | 0 | **3.98** |

Bottom film for top coat: TARF-P6111 photoresist was spun onto a 100mm P type 1-0-0 high resistivity Si wafer. Spinning conditions: 25 sec. at 3500 RPM, solution charge-2 ml. The wafer was calcined at 135°C for 1 min.

The HTES solutions were ambient aged for 2 days then spun onto a photoresist film. 1.2 ml of the solution was applied to the wafer during the dispense segment, 7 sec. at 500 RPM. After dispense, the wafer was spun for 35 sec. at 1500 RPM.

The wafer was split in half. One half, 5-A-1, was not calcined or heated in any way; the other half, 5-A-2, was calcined at 90°C for 1 min. on a hot plate. Both halves were immersed in deionized water for 30 sec. The films were allowed to air dry.

Another wafer, 5-B, was calcined at 135°C for 1 min. on a hot plate. The wafer was then placed on the spinner chuck. 1 ml of Optiyield™ photoresist developer was puddled in the center of the wafer. After 1 min., the developer was spun off (35 sec. at 3500 RPM). The wafer was sprayed with a small amount of deionized water during the spin.

From the results listed in Table 4, it can be seen that soft bakes are not necessary to achieve good water stability and to maintain solubility in aqueous base mixtures.

**Table 4:**

| | **Photo Resist Layer** | | **Top Coat** | | **Top Coat (water immersions)** | |
|---|---|---|---|---|---|---|
| | Thickness nm | Ref. index | Thickness nm | Ref. index | Thickness nm | |
| 5-A-1 amb. Water | 205.20 | 1.5267 | 62.0 | 1.4443 | 49.84 | |
| 5-A-2 90°C Water | 205.20 | 1.5267 | 45.45 | 1.425 | 51.69 | |
| 5-B base imm. | 227.12 | 1.5267 | 54.64 | 1.4326 | 0 | |

Example 6

27.0g of Schumacher propylene glycol propyl ether (PGPE or 1-proxy-2-propanol) was added to 1.92g of triethoxysilane (HTES) and the solution was briefly shaken. 0.06g of 0.05M citric acid solution was added and the solution was briefly shaken to mix. Next, 0.24g of deionized water was added to the mixture and 1 drop of 2.4% by weight aqueous tetramethylammonium hydroxide solution was added. The solution was shaken to mix. The pAcid of the solution was calculated to be:

| g silica | g solvent | G acid | g base | g water | kg total | [H+] | [OH-] | **pAcid** |
|---|---|---|---|---|---|---|---|---|
| 1.92 | 27 | 0.06 | 0.01 | 0.24 | 0.02923 | 0.000003 | 2.6E-06 | **4.86** |

After ambient aging overnight, the solution gelled. Films could not be processed any further. Accordingly, this example illustrates that processing of the top coat mixture is important to preparing a viable mixture.

Example 7

13.5g of Schumacher Propylene glycol propyl ether (PGPE or 1-proxy-2-propanol) was added to 0.96g of Aldrich Triethoxysilane (HTES). The solution was briefly shaken and 0.30g of 0.01 M maleic acid solution was added. The pAcid of the solution was calculated to be:

| g silica | g solvent | g acid | g base | g water | kg total | [H+] | [OH-] | **pAcid** |
|---|---|---|---|---|---|---|---|---|
| 0.96 | 13.5 | 0.3 | 0 | 0 | 0.01476 | 0.000003 | 0 | **3.69** |

Bottom film for top coat:TARF-P6111 photoresist was spun onto a 2-1-000mm P type 1-0-0 high resistivity Si wafer. Spinning conditions: 25 sec. at 3500 RPM, solution charge-2 ml. The wafer was calcined at 135°C for 1 min.

The HTES solutions were ambient aged for 1 day then spun onto the photoresist film. 1.2 ml of the solution was applied to the wafer during the dispense segment, 7 sec. at 500 RPM. After dispense, the wafer was spun for 35 sec. at 1500 RPM.

The wafer was split in half. One half, 7-A-1 was not calcined or heated in any way; the other half, 7-A-2, was calcined at 90°C for 1 min. Both were immersed in deionized water for 30 sec. The films were allowed to air dry.

Another wafer, 7-B, was calcined at 135°C for 1 min. on a hot plate. The wafer was then placed on the spinner chuck. 1 ml of Optiyield™ photoresist developer was puddled in the center of the wafer. After 1 min., the developer was spun off (35 sec. at 3500 RPM). The wafer was sprayed with a small amount of deionized water during the spin.

The results listed in Table 5 show that multiple carboxylic acids with a variety of pKa values are acceptable for use in accordance with the present compositions. The results also suggest that pre-bake or post-exposure bakes may not be necessary to maintain water stability and solubility in aqueous base mixtures.

**Table 5:**

| | **Photoresist Layer** | | **Top Coat** | | **Top Coat (immersions)** | |
|---|---|---|---|---|---|---|
| | Thickness nm | Ref. Index | Thickness nm | Ref. index | Thickness nm | |
| 7-A-1 amb. Water | 224.14 | 1.5267 | 50.4 | 1.4246 | 46.38 | |
| 7-A-2 90°C Water | 224.14 | 1.5267 | 48.48 | 1.4421 | 45.03 | |
| 7-B base imm. | 234.43 | 1.5267 | 44.87 | 1.4151 | 0 | |

Example 8

13.5g of propylene glycol propyl ether (PGPE or 1-proxy-2-propanol) was added to 0.96g of triethoxysilane (HTES) and the solution was briefly shaken. 0.30g of 0.001 M maleic acid solution was added and the solution was again shaken. The pAcid of the solution was calculated to be:

| g silica | g solvent | g acid | g base | g water | kg total | [H+] | [OH-] | **pAcid** |
|---|---|---|---|---|---|---|---|---|
| 0.96 | 13.5 | 0.3 | 0 | 0 | 0.01476 | 0.0000003 | 0 | **4.69** |

Bottom film for top coat: TARF-P6111 photoresist was spun onto a 100mm P type 1-0-0 high resistivity Si wafer. Spinning conditions: 25 sec. at 3500 RPM, solution charge-2 ml. The wafer was calcined at 135°C for 1 min.

The HTES solutions were ambient aged for 1 day then spun onto 2 photoresist film. 1.2 ml of the solution was applied to the wafer during the dispense segment, 7 sec. at 500 RPM. After dispense, the wafer was spun for 35 sec. at 1500 RPM.

The wafer was split in half. One half, 8-A-1, was not calcined or heated in any way; the other half, 8-A-2, was calcined at 90°C for 1 min. Both were immersed in deionized water for 30 sec. The films were allowed to air dry.

Another wafer was calcined at 135°C for 1 min. on a hot plate. The wafer was then placed on the spinner chuck. 1 ml of Optiyield™ photoresist developer was puddled in the center of the wafer. After 1 min. the developer was spun off (35 sec. at 3500 RPM). The wafer was sprayed with a small amount of deionized water during the spin.

The results listed in Table 6 suggests that, by varying the concentration of carboxylic acid, the useful pH range for compositions of the present invention is large.

**Table 6:**

| | **Photo Resist Layer** | | **Top Coat** | | **Top Coat (immersions)** | |
|---|---|---|---|---|---|---|
| | Thickness (nm) | Ref. index | Thickness (nm) | Ref. index | Thickness (nm) | |
| 8-A-1 amb. Water | 226.71 | 1.5267 | 58.7 | 1.4336 | 54.13 | |
| 8-A-2 90°C Water | 226.71 | 1.5267 | 53.7 | 1.4288 | 53.29 | |
| 8-B base imm. | 228.26 | 1.5267 | 53.77 | 1.4321 | 0 | |

Example 9:

1.23 g of tetramethoxysilane (TMOS) was combined with 0.695 g of purified methyltriacetoxysilane (MTAS) in a 1 oz polyethylene bottle. 27.0g of propylene glycol propyl ether (PGPE or 1-proxy-2-propanol) was added and the solution was briefly shaken. 1.25g of an acid/base solution containing 96% 0.1 M nitric acid and 4% 0.26M tetramethylammonium hydroxide aqueous solutions were added. The solution was shaken briefly to mix. The pAcid of the solution was calculated to be:

| g silica | g solvent | g acid | g base | g water | kg total | [H+] | [OH-] | **pAcid** |
|---|---|---|---|---|---|---|---|---|
| 1.925 | 27 | 1.2 | 0.05 | 0 | 0.030175 | 0.00012 | 1.3E-05 | **2.45** |

After ambient aging overnight, the solution was spun onto 4 P-type 1-0-0 Si wafers. Spinning conditions: 7 sec. at 500 RPM then 40 sec. at 1800 RPM, during dispense (500 RPM step), 1.2ml was applied to the wafer.

The 4 wafers were calcined at 3 different temperatures for 1 min. 90°C (9-A), 100°C (9-B), 110°C (9-C), and 120°C (9-D). Table 7 lists the film properties of each.

**Table 7:**

| Sample | Thickness (nm) | Ref. index |
|---|---|---|
| 9-A | 48.90 | 1.4610 |
| 9-B | 47.30 | 1.4610 |
| 9-C | 47.10 | 1.4610 |
| 9-D | 46.50 | 1.4610 |

The wafers were split into halves. One half of each was immersed in water. The other halves were immersed in 0.26M Optiyield™ photoresist developer for 1 min. Films were not removed in either. This was a visual observation only. Accordingly, this example illustrates that if the film does not include Si-H bonds or Si-OH bonds, the depolymerization in aqueous basic developer is slow, yet the water stability is good.

Examples 10-22

In these experiments, the dissolution rates of HTES/PGPE films were measured as a function of acid catalyst.

30% acid/base solution: 0.96g of HTES and 13.5g of PGPE were added to a bottle. The mixture was shaken for several minutes prior to the addition of 0.188g of 96% 0.1 M $HNO_3$ / 4% 0.25 M TMAH solution. The mixture was again shaken for several minutes to obtain a homogeneous solution. The solutions were allowed to age under ambient conditions prior to testing.

10% acid/base solution: 0.96g of HTES and 13.5g of PGPE were added to a bottle. The mixture was shaken for several minutes prior to the addition of 0.06g of 96% 0.1 M $HNO_3$ / 4% 0.25 M TMAH solution. The mixture was again shaken for several minutes to obtain a homogeneous solution. The solutions were allowed to age under ambient conditions prior to testing.

**Table 8: Dissolution Rates of HTES/PGPE and Various Acid Catalysts**

| Example | Film description | Dissolving fluid | Film thickness (nm) | Dissolution Rate (nm/sec) | pAcid |
|---|---|---|---|---|---|
| 10 | 0.19g acid/base sol'n (30%) | TMAH | 88.6 | 1.6 | 2.95 |
| 11 | 0.06g acid/base sol'n (10%) | TMAH | 127 | 6.5 | 3.45 |
| 12 | 0.44g acid/base sol'n (70%) | Optiyield™ CD | 96 | 4.7 | 2.6 |
| 13 | 0.06g acid/base sol'n (10%) | Optiyield™ CD | 95 | 34.7 | 3.45 |

(continued)

| Example | Film description | Dissolving fluid | Film thickness (nm) | Dissolution Rate (nm/sec) | pAcid |
|---|---|---|---|---|---|
| 14 | 0.44g acid/base sol'n (70%) | W2 | 149 | 7 | 2.6 |
| 15 | 0.06g acid/base sol'n (10%) | W2 | 311 | 5 | 3.45 |
| 16 | 0.1 M maleic acid | Optiyield™ CD | 72 | 0.5 | 2.69 |
| 17 | 0.1 M maleic acid | Water | 172 | 0 | 2.69 |
| 18 | 0.01 M maleic acid | Optiyield™ CD | 188 | 90 | 3.69 |
| 19 | 0.01 M maleic acid | Water | 80 | 0 | 3.69 |
| 20 | 0.36g citric acid | TMAH | 168 | 13.6 | 2.92 |
| 21 | 0.24g citric acid | TMAH | 128 | 69.1 | 3.09 |
| 22 | 0.12g citric acid | TMAH | 103 | 24.9 | 3.39 |
| Acid/base solution = 96% 0.1 M $HNO_3$ /4% 0.25 M TMAH | | | | | |

Example 23

Useful solvents for the silicon containing topcoat include alcohols, glycols, glycol ethers, glycol ether acetates, esters, ketones; the solvent preferably solubulizes all components of the film forming mixture including the silicon containing precursors, solvent, water, polymers, and catalysts; the solvent preferably does not dissolve or swell the photoresist; the solvent preferably does not deactivate the photoresist; the solvent preferably has the right physical properties, *i.e.*, surface tension, boiling point, evaporation rate, viscosity, to insure that the top coat mixture wets and adheres to all surfaces properly to give highly uniform films. Table 9 shows that PGME and PGMEA, which are solvents that are commonly used in the manufacturing of photoresist formulated products, are not useful solvents for top coat applications given that they dissolve the photoresist.

**Table 9:**

| **Photoresist** | | | | | | **Photoreist after solvent** | | | | |
|---|---|---|---|---|---|---|---|---|---|---|
| Solvent | Thickness | **average** | Ref. index | error | | Thickness | **Average** | Ref. index | error | Δ |
| | (nm) | | | % | | (nm) | | | % | |
| PGPE | 239.85 | | 1.5251 | 0.32 | | 247.21 | | 1.5231 | 0.30 | |
| | 239.87 | | 1.5260 | 0.34 | | 247.99 | | 1.5238 | 0.30 | |
| | 239.18 | **239.63** | 1.5254 | 0.32 | | 245.73 | **246.98** | 1.5238 | 0.30 | **7.34** |
| | | | | | | | | | | |
| PGMEA | 239.04 | | 1.5258 | 0.30 | | 233.96 | | 1.5283 | 0.24 | |
| | 239.79 | | 1.5257 | 0.31 | | 233.03 | | 1.5286 | 0.24 | |
| | 239.49 | **239.44** | 1.5258 | 0.30 | | 233.59 | **233.53** | 1.5285 | 0.25 | **-5.91** |
| | | | | | | | | | | |
| 1-pentanol | 238.22 | | 1.5265 | 0.32 | | 235.65 | | 1.5275 | 0.25 | |
| | 238.05 | | 1.5268 | 0.33 | | 237.36 | | 1.5271 | 0.25 | |
| | 237.45 | **237.91** | 1.5263 | 0.32 | | 237.06 | **236.69** | 1.5273 | 0.26 | **-1.22** |
| | | | | | | | | | | |
| EtOH | 237.66 | | 1.5266 | 0.34 | | 235.60 | | 1.5277 | 0.25 | |
| | 238.51 | | 1.5261 | 0.35 | | 236.22 | | 1.5277 | 0.25 | |
| | 238.40 | **238.19** | 1.5258 | 0.35 | | 236.59 | **236.14** | 1.5277 | 0.25 | **-2.05** |
| | | | | | | | | | | |
| 4-methyl-2-pentanol | 247.12 | | 1.5260 | 0.35 | | 243.55 | | 1.5260 | 0.27 | |
| | 245.18 | | 1.5254 | 0.35 | | 250.57 | | 1.5254 | 0.28 | |
| | 245.11 | **245.80** | 1.5264 | 0.35 | | 238.53 | **244.22** | 1.5267 | 0.25 | **-1.59** |
| | | | | | | | | | | |
| n-propanol | 239.15 | | 1.5263 | 0.30 | | 237.76 | | 1.5264 | 0.24 | |
| | 238.54 | | 1.5270 | 0.33 | | 236.82 | | 1.5276 | 0.24 | |
| | 239.33 | **239.01** | 1.5266 | 0.35 | | 236.91 | **237.16** | 1.5274 | 0.25 | **-1.84** |

(continued)

| **Photoresist** | | | | | | **Photoreist after solvent** | | | | |
|---|---|---|---|---|---|---|---|---|---|---|
| Solvent | Thickness | **average** | Ref. index | error | | Thickness | **Average** | Ref. index | error | Δ |
| | (nm) | | | % | | (nm) | | | % | |
| | | | | | | | | | | |
| PGME | 243.50 | | 1.5257 | 0.34 | | 229.83 | | 1.5308 | 0.24 | |
| | 243.20 | | 1.5271 | 0.35 | | 233.02 | | 1.5304 | 0.25 | |
| | 250.97 | **245.89** | 1.5256 | 0.37 | | 231.83 | **231.56** | 1.5336 | 0.27 | **14.33** |
| | | | | | | | | | | |
| 1-butanol | 243.72 | | 1.5254 | 0.35 | | 242.19 | | 1.5255 | 0.27 | |
| | 243.83 | | 1.5252 | 0.37 | | 241.63 | | 1.5247 | 0.25 | |
| | 243.41 | **243.65** | 1.5251 | 0.37 | | 246.02 | **243.28** | 1.5254 | 0.28 | **-0.37** |

PGPE = propylene glycol propyl ether
PGMEA = propylene glycol methyl ether acetate
EtOH = ethanol
PGME = propylene glycol methyl ether

Example 24

Transparency of the silicate containing films were measured with a variable angle spectroscopic ellipsometer for the vacuum ultraviolet [VUV-VASE] (J.A. Woollam Co. Inc., Lincoln, Nebraska). Table 10 lists illustrates the transparency of a top coat material comprising HTES / $HNO_3$/ PGPE as a function of temperature. The refractive index and scattering factors are from the VUV-VASE at 193 nm:

**Table 10:**

| Description | Thickness (Å) | N | K |
|---|---|---|---|
| As-spun | 417 | 1.5418 | 0.0 |
| 90°C | 422 | 1.5484 | 0.0 |
| 110°C | 410 | 1.5401 | 0.0 |
| 135°C | 410 | 1.5350 | 0.0 |

The top coat materials according to the present invention are tansparent at 193 nm.

Example 25

A wafer coated with a bottom antireflective coating was coated with a photoresist, JSR 1682J (Japanese Silicon Rubber Co.). The top coat solution of Example 7 was spun at 1520 RPM and baked at 90°C for 60sec. The wafer was then exposed to a 193nm light with an ASML /1150i immersion scanner where water was used as the immersion fluid using. The wafer was then baked at 135°C for 60sec and developed in 0.26N TMAH developer.

Comparative example: A wafer coated with a bottom antireflective coating was coated with a photoresist, JSR 1682J (Japanese Silicon Rubber Co.). The top coat solution of Example 7 was spun at 1520 RPM and baked at 90°C for 60 sec. The wafer was then exposed to a 193nm light with dry lithography scanner (ASML PAS 5500/1100). The wafer was then baked at 135°C for 60 sec and developed in 0.26N TMAH developer.

Comparative example: A wafer coated with a bottom antireflective coating was coated with a photoresist, JSR 1682J (Japanese Silicon Rubber Co.) of 280nm. The wafer was then exposed to a 193nm light with dry lithography scanner (ASML PAS 5500/1100). The wafer was then baked at 135°C for 60sec and developed in 0.26N TMAH developer.

The resist images obtained from the 3 tests above were examined using a scanning electron microscope. Specifically, the 80nm 1:1 line/space features showed no significant difference for all 3 tests, indicating that the top coat of Example 7 can be used without any negative impact on resist profile and process latitude. There was also no difference when it was used under normal dry condition and wet condition in an immersion scanner.

Example 26: Leaching Performance for Top Coats

Ultra pure water (12mL) was flown over the wafer surface coated with top coats prepared according to Example 7 over a photoresist JSR 1682J (Japanese Silicon Rubber Co.) and collected for LC/MS analysis. $C_1$-$C_{12}$ sulfonates which are the anions of the photoacid generators in the resist were analyzed to illustrate the impact of top coats as barrier coating. The results are shown in Table 11.

**Table 11: Summary of Sulfonates in Water Samples**

| Sample | C4 Sulfonate* (ng/mL) |
|---|---|
| Resist only | > 80 |
| Resist + TC of Example 7 (17nm) | 4.9 |
| Resist + TC of Example 7 (36nm) | 3.2 |
| * Other sulfonates were not detected in the samples | |

The results show that the top coat of Example 7 is an effective barrier for the leaching of photoacid generators. Typically, if leaching results are <5ng/mL, the top coats are considered safe to be used in an immersion scanner without causing any detrimental effects to the lens.

Examples 27 and 28:

For examples 27 and 28, unless stated otherwise, exemplary films were deposited onto four-inch prime silicon (1-0-0) high resistivity (10-15 Ω cm) wafers and lithographically processed in the following manner. The deposition process for the photoresist was conducted by dispensing 1 milliliter (mL) of the composition through a 0.2 micron (μm) Teflon filter and the wafer was spun on a rotating turntable at 3500 rpm for 35 seconds. After the photoresist was deposited on the wafer the corresponding film was followed by a post apply bake (PAB) at 135 °C for 1 minute. Both the PAB and PEB were conducted using either a Cimarec Model No. 2 or Cimarec Model No. 3 hot plate manufactured by Thermolyne. On top of each hot plate was an aluminum plate with a thermocouple inserted into a hole in each plate for monitoring the temperature and relaying the temperature to a controller. The temperature of each hot plate was controlled by a temperature controller R/S Digisense temperature controller sold by Cole-Parmer. The top coat was then deposited onto the photoresist in the same manner as the photoresist was applied to the wafer except it was spun for 7 seconds at 500 revolutions per minute (rpm) and then ramped to 1500 rpm for 35 seconds to form the top coat. This dual layer film was then subjected to another PAB at 90 °C for 1 min. The wafers were spun on a Model WS-400A-8-TFM/LITE rotating turntable manufactured by Laurell Technologies Corporation of North Wales, PA. The photoresist used for these experiments was TARF-P6111 (product name by Tokyo Ohka Kogyo Co.).

After the top coat was applied to the photoresist, unless stated otherwise, a chromium on quartz mask having patterns with features in the size range of 30μ down to 4μ was placed in contact with the film then exposed to an ionizing radiation source.

The deposition and masking was conducted as described above. The unmasked portion of these films, were then exposed to a broad band ultraviolet light source referred to herein as "UV1", manufactured by Fusion Systems using a "D" bulb, for 1-5 seconds.

Example 27: HTES, 1-butanol formulation

0.96g of Aldrich triethoxysilane (HTES) and 13.5g of Aldrich 1-butanol were added to a bottle. The mixture was briefly shaken prior to adding 0.3g 0.001 M nitric acid solution. The mixture was shaken for about 1 minute. The pAcid of the solution was calculated to be:

| g silica | g solvent | g acid | g base | g water | kg total | [H+] | [OH-] | **pAcid** |
|---|---|---|---|---|---|---|---|---|
| 0.96 | 13.5 | 0.3 | 0 | 0 | 0.01476 | 0.0000003 | 0 | **4.69** |

Bottom film for topcoat: About 1 ml TARF-P6111 photoresist was spun onto a 100mm type 1-0-0 high resistivity Si wafer (spinning conditions: 35 sec at 3500 RPM). The wafer was calcined at 135°C for 1 min. on a hot plate. The film was submitted for ellipsometry to determine the film's thickness.

The HTES solutions were ambient aged overnight then spun onto the photoresist film. About 1ml of the HTES was dispensed onto the photoresist film. The solution was filtered with a 0.2μ syringe filter when it was applied to the wafer (spinning conditions: 7 sec. at 500 RPM then 35 sec. at 1500 RPM). The wafer was calcined at 135°C on a hot plate. The wafer was submitted for ellipsometry to determine the thickness of the topcoat.

The wafer was placed on the spinner chuck. About 1ml of Optiyield™ photoresist developer was puddled in the center in the center of the wafer. After 1 min., the developer was spun off (35 sec. at 3500 RPM). The wafer was rinsed with a small amount of deionized water during the spin. The wafer was submitted for ellipsometry to determine if the topcoat was completely removed. Table 12 demonstrates that the top coat according to the present invention is readily removed by contact with an aqueous base without negatively impacting the underlying resist.

**Table 12: Film Thickness Before and After Development**

| **Before Development** Photoresist Thickness (nm) | **Before Development** Top Coat Thickness (nm) | **After Development** Photoresist Thickness (nm) | **After Development** Top Coat Thickness (nm) |
|---|---|---|---|
| 204.49 | 61.45 | 199.50 | 1.57 |

The deposition and masking was conducted as described above. The unmasked portion of the film, were then exposed to UV1 for 3 seconds. After exposure the films went through a post exposure bake (PEB) at 135°C for 1 minute to generate a latent image unless otherwise noted. After PEB, film 29 was then developed using an aqueous 0.26 N TMAH developer solution for 30 seconds. The wafer was removed from the bath and rinsed with water. After processing, the wafer only contained the exposed film with the proper positive image also described as a patterned coated substrate. The exemplary film was observed by various compound optical microscopes to detect patterned images. Film 27 exhibited

trenches resolved down 4μm (the limit of the mask), lines were resolved down to 8 μm.

Example 28: HTES, 3,3,3-trifluoropropyltrimethoxysilane, and 1-butanol

0.93g of Aldrich triethoxysilane (HTES), 0.04g of 3,3,3-trifluoropropyltrimethoxysilane, and 13.5g of Aldrich 1-butanol were added to a bottle. The mixture was briefly shaken prior to adding 0.3g of 0.001 M nitric acid solution. The mixture was shaken for about 1 minute. The pAcid of the solution was calculated to be:

| g silica | g solvent | g acid | g base | g water | kg total | [H+] | [OH-] | **pAcid** |
|---|---|---|---|---|---|---|---|---|
| 0.97 | 13.5 | 0.3 | 0 | 0 | 0.01477 | 0.0000003 | 0 | **4.69** |

Bottom film for topcoat: About 1ml TARF-P6111 photoresist was spun onto a 100mm type 1-0-0 high resistivity Si wafer. Spinning conditions: 35 sec at 3500 RPM. The wafer was calcined at 135°C for 1 min. on a hot plate. The film was submitted for ellipsometry to determine the film's thickness.

The HTES solutions were ambient aged overnight then spun onto the photoresist film. About 1ml of the HTES was dispensed onto the photoresist film. The solution was filtered with a 0.2μ syringe filter when it was applied to the wafer. Spinning conditions: 7 sec. at 500 RPM then 35 sec. at 1500 RPM. The wafer was calcined at 135°C on a hot plate. The wafer was submitted for ellipsometry to determine the thickness of the topcoat.

The wafer was placed on the spinner chuck. 1 ml of Optiyield photoresist developer was puddled in the center in the center of the wafer. After 1 min., the developer was spun off (35 sec. at 3500 RPM). The wafer was rinsed with a small amount of deionized water during the spin. The wafer was submitted for ellipsometry to determine if the topcoat was completely removed. Table 13 demonstrates that the top coat according to the present invention is readily removed by contact with an aqueous base developer without negatively impacting the underlying resist. Moreover, the added hydrophobicity due to the presence of the fluorine atoms did not negatively impact the depolymerization rate in the developer solution.

**Table 13: Film Thickness Before and After Development**

| **Before Development** Resist Thickness (nm) | **Before Development** Top Coat Thickness (nm) | **After Development** Resist Thickness (nm) | **After Development** Top Coat Thickness (nm) |
|---|---|---|---|
| 200.99 | 60.50 | 200.99 | 0.00 |

The HTES solutions were ambient aged overnight then spun onto the photoresist film (TARF-P6111). The deposition and masking was conducted as described above. The unmasked portion of the film, were then exposed to UV1 for 3 seconds. After exposure the films went through a post exposure bake (PEB) at 135°C for 1 minute. After PEB, film 30 was then developed using an aqueous 0.26 N TMAH developer solution for 30 seconds. The wafer was removed from the bath and rinsed with water. After processing, the wafer only contained the exposed film with the proper positive image also described as a patterned coated substrate. The exemplary film was observed by various compound optical microscopes to detect patterned images. Film 30 exhibited trenches and lines resolved down 4μm (the limit of the mask).

Example 29: Triethoxysilane and 1-Butanol

54.0g Aldrich 1-butanol was added to 3.85g Aldrich triethoxysilane in a 4 oz. poly bottle. The solution was shaken and 0.48g 0.0025M nitric acid was added and mixed again. The pAcid of the solution was calculated to be:

| g silica | g solvent | g acid | g base | g water | kg total | [H+] | [OH-] | **pAcid** |
|---|---|---|---|---|---|---|---|---|
| 3.85 | 54 | 0.48 | 0 | 0 | 0.05833 | 0.0000012 | 0 | **4.69** |

Bottom film for top coat: TARF-P6111 photoresist was spun onto a 100mm P type 1-0-0 high resistivity Si wafer. Spinning conditions: 40 sec. at 3500 RPM, solution charge-1 ml. The wafer was calcined at 135°C for 1 min. on a hot plate.

The HTES solution was ambient aged for 5 days then spun onto a photoresist film. 1 ml of the solution was applied to the wafer during the dispense segment, 7 sec. at 500 RPM. After dispense, the wafer was spun for 35 sec. at 1500 RPM. The wafer was calcined at 135°C for 1 min. on a hot plate.

The wafer was then placed on the spinner chuck. 1 ml of Optiyeild™ Photoresist Developer was puddled in the center of the wafer. After 1 min. the developer was spun off (35 sec. at 3500 RPM). The wafer was sprayed with a small amount of deionized water during the spin. The following film properties were measured on the stripped portion was a Sentech SE800 ellipsometer.

| Photoresist Thickness (nm) | Top Coat Thickness (nm) | Top Coat after Developer (nm) | % Topcoat Loss | Photoresist Thickness (nm) | % Photoresist Retained |
|---|---|---|---|---|---|
| 202.4700 | 63.98 | 1.05 | 98.4 | 201.26 | 99.4 |

This example shows that the pAcid of the solution and the choice of solvent are important parameters to produce aqueous base depolymerizable films that do not affect the photoresist thickness or performance.

<u>Example 30:</u> Triethoxysilane and 1-Butanol/1-Propanol

3.85g Aldrich triethoxysilane was added to a 4 oz. polyethylene bottle. 43.2g of Aldrich 1-butanol and 10.8g Aldrich 1-propanol were added. The solution was shaken and 1.2g 0.001 M nitric acid was added and mixed again. The pAcid of the solution was calculated to be:

| g silica | g solvent | g acid | g base | g water | kg total | [H+] | [OH-] | **pAcid** |
|---|---|---|---|---|---|---|---|---|
| 3.85 | 54 | 1.2 | 0 | 0 | 0.05905 | 0.0000012 | 0 | **4.69** |

Bottom film for top coat: TARF-P6111 photoresist was spun onto a 100mm P type 1-0-0 high resistivity Si wafer. Spinning conditions: 40 sec. at 3500 RPM, solution charge-1 ml. The wafer was calcined at 135°C for 1 min. on a hot plate.

The HTES solution was ambient aged for 7 days then spun onto a photoresist film. 1 ml of the solution was applied to the wafer during the dispense segment, 7 sec. at 500 RPM. After dispense, the wafer was spun for 35 sec. at 1500 RPM. The wafer was calcined at 135°C for 1 min. on a hot plate.

The wafer was then placed on the spinner chuck. 1 ml of Optiyeild™ Photoresist Developer was puddled in the center of the wafer. After 1 min. the developer was spun off (35 sec. at 3500 RPM). The wafer was sprayed with a small amount of deionized water during the spin. The following film properties were measured on the stripped portion was a Sentech SE800 ellipsometer.

| photoresist thickness (nm) | Topcoat thickness (nm) | Topcoat after strip (nm) | % Topcoat loss | photoresist thickness (nm) | % photoresist retained |
|---|---|---|---|---|---|
| 205.29 | 54.15 | 0 | 100 | 205.07 | 99.9% |

This example illustrates that mixtures of solvents may not affect the photoresist or change the depolymerization of the top coat in aqueous base-containing solutions. Such mixtures, however, may aid in the storage stability of the film forming mixture.

<u>Example 31:</u> Triethoxysilane and 1-Propanol

54.0g Aldrich 1-Propanol was added to 3.85g of Aldrich triethoxysilane in a 4 oz. polyethylene bottle. The solution was shaken and 1.2g 0.001 M nitric acid was added and the solution was mixed again. The pAcid of the solution was calculated to be:

| g silica | g solvent | g acid | g base | g water | kg total | [H+] | [OH-] | **pAcid** |
|---|---|---|---|---|---|---|---|---|
| 3.85 | 54 | 1.2 | 0 | 0 | 0.05905 | 0.0000012 | 0 | **4.69** |

Bottom film for top coat: TARF-P6111 photoresist was spun onto a 100mm P type 1-0-0 high resistivity Si wafer. Spinning conditions: 40 sec. at 3500 RPM, solution charge-1 ml. The wafer was calcined at 135°C for 1 min. on a hot plate.

The HTES solution was ambient aged for 13 days then spun onto a photoresist film. 1 ml of the solution was applied to the wafer during the dispense segment, 7 sec. at 500 RPM. After dispense, the wafer was spun for 35 sec. at 1500 RPM. The wafer was calcined at 135°C for 1 min. on a hot plate.

The wafer was then placed on the spinner chuck and 1 ml of Optiyeild™ Photoresist Developer was puddled in the center of the wafer. After 1 min. the developer was spun off (35 sec. at 3500 RPM). The wafer was sprayed with a small amount of deionized water during the spin. The following film properties were measured on the stripped portion was a Sentech SE800 ellipsometer.

| photoresist thickness (nm) | Topcoat thickness (nm) | Topcoat after strip (nm) | % Topcoat loss | photoresist thickness (nm) | % photoresist retained |
|---|---|---|---|---|---|
| 275.98 | 69.73 | 1.01 | 98.6 | 273.04 | 98.9 |

This example demonstrates that changing solvents and pAcid can help to improve the storage stability of the top coat mixture without affecting the photoresist or changing the depolymerization of the topcoat in aqueous base-containing solutions.

Example 32: Triethoxysilane and 1-Butanol

54.0g of Aldrich 1-butanol was added to 3.85g Aldrich triethoxysilane in a 4 oz. polyethylene bottle and the solution was shaken. 0.1.2g of 0.1 M nitric acid was added and the solution was mixed again. The pAcid of the solution was calculated to be:

| g silica | g solvent | g acid | g base | g water | kg total | [H+] | [OH-] | **pAcid** |
|---|---|---|---|---|---|---|---|---|
| 3.85 | 54 | 1.2 | 0 | 0 | 0.05905 | 0.00012 | 0 | **2.69** |

Bottom film for top coat: TARF-P6111 photoresist was spun onto a 100mm P type 1-0-0 high resistivity Si wafer. Spinning conditions: 40 sec. at 3500 RPM, solution charge-1 ml. The wafer was calcined at 135°C for 1 min. on a hot plate.

The HTES solution was ambient aged for 13 days then spun onto a photoresist film. 1 ml of the solution was applied to the wafer during the dispense segment, 7 sec. at 500RPM. After dispense, the wafer was spun for 35 sec. at 1500 RPM. The wafer was calcined at 135°C for 1 min. on a hot plate.

The wafer was then placed on the spinner chuck. 1 ml of Optiyeild™ Photoresist Developer was puddled in the center of the wafer. After 1 min., the developer was spun off (35 sec. at 3500 RPM). The wafer was sprayed with a small amount of deionized water during the spin. The following film properties were measured on the stripped portion was a Sentech SE800 ellipsometer.

| photoresist thickness (nm) | Topcoat thickness (nm) | Topcoat after strip (nm) | % Topcoat loss | photoresist thickness (nm) | % photoresist retained |
|---|---|---|---|---|---|
| 275.82 | 48.22 | 0.5 | 99.0 | 274.65 | 99.6 |

This example shows that more hydrophobic solvents are capable of coating the photoresist effectively without affecting the photoresist or changing the depolymerization of the topcoat in aqueous basic developers.

Example 33:

277.7 g of Aldrich 1-butanol was added to 19.75g of Aldrich triethoxysilane in a polyethylene bottle. The solution was shaken briefly and 2.47g of 0.0025M nitric acid was added and the solution again was mixed. The pAcid of the solution was calculated to be 4.69.

Bottom film for top coat: TARF-P6111 photoresist was spun onto a 100mm P type 1-0-0 high resistivity Si wafer. Spinning conditions: 40 sec. at 3500 RPM, solution charge-1 ml. The wafer was calcined at 135°C for 1 min. on a hot plate.

The HTES solution was ambient aged for 4 days then spun onto a photoresist film. 1 ml of the solution was applied to the wafer during the dispense segment, 7 sec. at 500 RPM. After dispense, the wafer was spun for 35 sec. at 1500 RPM. The wafer was calcined at 135°C for 1 min. on a hot plate. This resulted in a top coat with a thickness of 50.3 nm.

Example 34:

277.7 g of Aldrich 1-butanol was added to 19.19g of Aldrich triethoxysilane and 0.79 g of 3,3,3-trifluoropropyltrimethoxysilane in a polyethylene bottle. The solution was shaken to mix and 2.47g of 0.0025M nitric acid was added and the solution was mixed again. The pAcid of the solution was calculated to be 4.69.

Bottom film for top coat: TARF-P6111 photoresist was spun onto a 100mm P type 1-0-0 high resistivity Si wafer. Spinning conditions: 40 sec. at 3500 RPM, solution charge-1 ml. The wafer was calcined at 135°C for 1 min. on a hot plate.

The HTES solution was ambient aged for 4 days then spun onto a photoresist film. 1 ml of the solution was applied to the wafer during the dispense segment, 7 sec. at 500 RPM. After dispense, the wafer was spun for 35 sec.

at 1500 RPM. The wafer was calcined at 135°C for 1 min. on a hot plate. This resulted in a top coat with a thickness of 62.7 nm.

Example 35:

277.7 g of Aldrich 1-butanol was added to 17.81g of Aldrich triethoxysilane and 2.63 g of 3,3,3-trifluoropropyltrimethoxysilane in a polyethylene bottle. The solution was mixed briefly and 2.47g of 0.0025M nitric acid was added and the solution was again mixed. The pAcid of the solution was calculated to be 4.69.

Bottom film for top coat: TARF-P6111 photoresist was spun onto a 100mm P type 1-0-0 high resistivity Si wafer. Spinning conditions: 40 sec. at 3500 RPM, solution charge-1 ml. The wafer was calcined at 135°C for 1 min. on a hot plate.

The HTES solution was ambient aged for 4 days then spun onto a photoresist film. 1 ml of the solution was applied to the wafer during the dispense segment, 7 sec. at 500 RPM. After dispense, the wafer was spun for 35 sec. at 1500 RPM. The wafer was calcined at 135°C for 1 min. on a hot plate. This resulted in a top coat with a thickness of 49.4 nm.

Each of the samples from example 33, 34, and 35 were treated as follows. A series of water droplets were placed across the wafer at various time intervals. After a designated period of time the water was removed by blowing dry nitrogen across the sample until the sample appeared to be dry. This will be designated process condition 1.

Another series of droplets were placed onto a new area of the wafer at various time intervals. After a designated period of time the water was removed by blowing dry nitrogen across the sample until the sample appeared to be dry. The sample was then heated at 100°C for 2 minutes. This will be designated process condition 2.

Another series of droplets were placed onto a new area of the wafer at various time intervals. After a designated period of time the water was evaporated by placing the samples with the water droplets still on the surface onto a hot plate at 100°C for 1.5 minutes. This will be designated as process condition 3.

At the conclusion of each of the process conditions the samples were examined under an optical microscope to determine if there were any water mark defects on the surface of the top coat. If there was a water mark defect observed, yes (Y) is noted in the following table; otherwise no (N) is noted. The data is summarized in Table 14.

Table 14: Water Mark Defects on Hydrophobic Top Coats

| | | ***Water Droplet Time on the Surface of the Film (water defect Y or N)*** | | | |
|---|---|---|---|---|---|
| **Example #** | **Process Condition** | **0.5 min** | **1.5 min** | **5.5 min** | **10.5 min** |
| 33 | 1 | N | N | N | N |
| 33 | 2 | N | N | N | N |
| 33 | 3 | N | N | N | N |
| | | | | | |
| 34 | 1 | N | N | N | N |
| 34 | 2 | N | N | N | N |
| 34 | 3 | N | N | N | N |
| | | | | | |
| 35 | 1 | N | N | N | N |
| 35 | 2 | N | N | N | N |
| 35 | 3 | N | N | N | N |

The foregoing examples and description of the preferred embodiments should be taken as illustrating, rather than as limiting the present invention as defined by the claims. As will be readily appreciated, numerous variations and combinations of the features set forth above can be utilized without departing from the present invention as set forth in the claims. Such variations are not regarded as a departure from the spirit and scope of the invention, and all such variations are intended to be included within the scope of the following claims.

## Claims

1. A method for making a depolymerizable top coat material for use in a lithographic process, the method comprising:

   applying a layer of a composition adjacent to a layer of photoresist, the composition comprising a silicon-containing polymer prepared by sol-gel processing at least one silica source; and
   subjecting the layer of top coat material to a temperature of from about 50 to about 200°C, wherein the silicon-containing polymer in the top coat material depolymerizes upon exposure to an aqueous base-containing solution.

2. The method of Claim 1 wherein the at least one silica source comprises at least one silica source of the formula $R_aSi(OR^1)_{4-a}$,
   wherein:

   R independently represents a hydrogen atom, a fluorine atom, a fluoroalky group, a perfluoroalkyl group, or a monovalent organic group;
   $R^1$ independently represents a monovalent organic group; and
   a is an integer ranging from 1 to 3.

3. The method of Claim 2 wherein R is a hydrogen atom.

4. The method of Claim 2 wherein the at least one silica source is at least one compound selected from the group consisting of methyltrimethoxysilane, methyltriethoxysilane, methyltri-n-propoxysilane, methyltriisopropoxysilane, ethyltrimethoxysilane, ethyltriethoxysilane, dimethyldimethoxysilane, dimethyldiethoxysilane, diethyldimethoxysilane, diethyldiethoxysilane, trimethoxysilane, triethoxysilane, tri-n-propoxysilane, triisopropoxysilane, tri-n-butoxysilane, tri-sec-butoxysilane, tri-tert-butoxysilane, and andtriphenoxysilane.

5. The method of Claim 4 wherein the at least one silica source comprises triethoxysilane.

6. The method of Claim 2 wherein the at least one silica source comprises Si, O, H, C, and F.

7. The method of Claim 2 wherein the silica source comprises at least one fluoroalkyl group.

8. The method of Claim 2 wherein the silica source comprises at least one perfluoroalkyl group.

9. The method of Claim 6 wherein the at least one silica source comprises at least one compound selected from the group consisting of 3,3,3-trifluoropropyltrimethoxysilane, pentafluorophenyltriethoxysilane, pentafluorophenylpropyltrimethoxysilane, (tridecafluoro-1,1,2,2-tetrahydrooctyl)-triethoxysilane, (tridecafluoro-1,1,2,2-tetrahydrooctyl)trimethoxysilane, 1H, H,2H,2H-perfluorodecyltriethoxysilane, nonafluorohexyltrimethoxysilane, heptade-cafluoro-1,1,2,2-tetrahydrodecyl)trimethoxysilane, and (heptadecafluoro-1,1,2,2-tetrahydrodecyl)triethoxysilane.

10. The method of Claim 9 wherein the at least one silica source comprises 3,3,3-trifluoropropyltrimethoxysilane.

11. The method of Claim 1 wherein the at least one silica source comprises:

    at least one compound selected from the group consisting of methyltrimethoxysilane, methyltriethoxysilane, methyltri-n-propoxysilane, methyltriisopropoxysilane, ethyltrimethoxysilane, ethyltriethoxysilane, dimethyldimethoxysilane, dimethyldiethoxysilane, diethyldimethoxysilane, diethyldiethoxysilane, trimethoxysilane, triethoxysilane, tri-n-propoxysilane, triisopropoxysilane, tri-n-butoxysilane, tri-sec-butoxysilane, tri-tert-butoxysilane, and andtriphenoxysilane; and
    at least one compound selected from the group consisting of 3,3,3-trifluoropropyltrimethoxysilane, pentafluorophenyltriethoxysilane, pentafluorophenylpropyltrimethoxysilane, (tridecafluoro-1,1,2,2-tetrahydrooctyl)-triethoxysilane, (tridecafluoro-1,1,2,2-tetrahydrooctyl)trimethoxysilane, 1H, 1H,2H,2H-perfluorodecyltriethoxysilane, nonafluorohexyltrimethoxysilane, heptadecafluoro-1,1,2,2-tetrahydrodecyl)trimethoxysilane, and (heptadecafluoro-1,1,2,2-tetrahydrodecyl)triethoxysilane.

12. The method of Claim 11 wherein the at least one silica source comprises triethoxysilane and 3,3,3-trifluoropropyltrimethoxysilane.

**13.** The method of any one of Claims 2 to 12 wherein the top coat further comprises a chromophore.

**14.** The method of Claim 13 wherein the chromophore comprises 5,8-dihydroxy-1,4-napthoquinone.

**15.** The method of Claim 13 wherein the chromophore comprises 2,4-hexadienoic acid.

**16.** A method for forming a patterned layer on an atricle, the method comprising:

providing an article comprising a material layer;
forming a photoresist layer on the material layer;
applying a top coat material adjacent to the photoresist layer, thereby forming a coated article, the top coat material comprising a silicon-containing polymer prepared by sol-gel processing at least one silica source;
exposing the photoresist layer to imaging irradiation through a patterned mask and through the top coat material;
contacting the article with an aqueous base-containing solution to remove simultaneously the top coat material and portions of the photoresist layer, thereby forming a patterned photoresist layer on the material layer; and
transferring the pattern in the photoresist layer to the material layer, wherein the polymer component of the top coat material is depolymerized upon contact with the aqueous base-containing solution.

**17.** The method of Claim 16 wherein the at least one silica source comprises at least one silica source of the formula $R_aSi(OR^1)_{4-a}$,
wherein:

R independently represents a hydrogen atom, a fluorine atom, a fluoroalky group, a perfluoroalkyl group, or a monovalent organic group;
$R^1$ independently represents a monovalent organic group; and
a is an integer ranging from 1 to 3.

**18.** The method of Claim 17 wherein R is a hydrogen atom.

**19.** The method of Claim 18 wherein the at least one silica source of the formula $R_{a-}Si(OR^1)_{4-a}$ is at least one compound selected from the group consisting of methyltrimethoxysilane, methyltriethoxysilane, methyltri-n-propoxysilane, methyltriisopropoxysilane, ethyltrimethoxysilane, ethyltriethoxysilane, dimethyldimethoxysilane, dimethyldiethoxysilane, diethyldimethoxysilane, diethyldiethoxysilane, trimethoxysilane, triethoxysilane, tri-n-propoxysilane, triisopropoxysilane, tri-n-butoxysilane, tri-sec-butoxysilane, tri-tert-butoxysilane, and andtriphenoxysilane.

**20.** The method of Claim 19 wherein the compound is triethoxysilane.

**21.** The method of Claim 16 wherein the at least one silica source comprises Si, O, H, C, and F.

**22.** The method of Claim 2 wherein the silica source comprises at least one fluoroalkyl group.

**23.** The method of Claim 17 wherein the silica source comprises at least one perfluoroalkyl group.

**24.** The method of Claim 17 wherein the at least one alkyl group comprises at least one fluoroalkyl group.

**25.** The method of Claim 21 wherein the at least one silica source comprises at least one compound selected from the group consisting of 3,3,3-trifluoropropyltrimethoxysilane, pentafluorophenyltriethoxysilane, pentafluorophenylpropyltrimethoxysilane, (tridecafluoro-1,1,2,2-tetrahydrooctyl)-triethoxysilane, (tridecafluoro-1,1,2,2-tetrahydrooctyl)trimethoxysilane, 1 H, H,2H,2H-perfluorodecyltriethoxysilane, nonafluorohexyltrimethoxysilane, heptade-cafluoro-1,1,2,2-tetrahydrodecyl)trimethoxysilane, and (heptadecafluoro-1,1,2,2-tetrahydrodecyl)triethoxysilane.

**26.** The method of Claim 25 wherein the silica source comprises 3,3,3-trifluoropropyltrimethoxysilane.

**27.** The method of Claim 16 wherein the at least one silica source comprises:

at least one compound selected from the group consisting of methyltrimethoxysilane, methyltriethoxysilane, methyltri-n-propoxysilane, methyltriisopropoxysilane, ethyltrimethoxysilane, ethyltriethoxysilane, dimethyldimethoxysilane, dimethyldiethoxysilane, diethyldimethoxysilane, diethyldiethoxysilane, trimethoxysilane, triethoxysilane, tri-n-propoxysilane, triisopropoxysilane, tri-n-butoxysilane, tri-sec-butoxysilane, tri-tert-butoxysilane, and andtriphenoxysilane; and
at least one compound selected from the group consisting of 3,3,3-trifluoropropyltrimethoxysilane, pentafluorophenyltriethoxysilane, pentafluorophenylpropyltrimethoxysilane, (tridecafluoro-1,1,2,2-tetrahydrooctyl)-triethoxysilane, (tridecafluoro-1,1,2,2-tetrahydrooctyl)trimethoxysilane, 1H,1H,2H,2H-perfluorodecyltriethoxysilane, nonafluorohexyltrimethoxysilane, heptadecafluoro-1,1,2,2-tetrahydrodecyl)trimethoxysilane, and (heptadecafluoro-1,1,2,2-tetrahydrodecyl)triethoxysilane.

**28.** The method of Claim 27 wherein the at least one silica source comprises triethoxysilane and 3,3,3-trifluoropropyltrimethoxysilane.

**29.** The method of any one of Claims 16 to 28 wherein the top coat material further comprises a chromophore.

**30.** The method of Claim 29 wherein the chromophore comprises 5,8-dihydroxy-1,4-napthoquinone.

**31.** The method of Claim 29 wherein the chromophore comprises 2,4-hexadienoic acid.

**32.** A composition comprising:

a silicon-containing polymer prepared by sol-gel processing of at least one silica source;
a stabilizer;
a solvent;
optionally a catalyst; and
optionally water,

wherein the pH of the composition is less than 8.

**33.** The composition of Claim 32 wherein the at least one silica source comprises at least one silica source of the formula $R_aSi(OR^1)_{4-a}$,
wherein:

R independently represents a hydrogen atom, a fluorine atom, a fluoroalky group, a perfluoroalkyl group, or a monovalent organic group;
$R^1$ independently represents a monovalent organic group; and
a is an integer ranging from 1 to 3.

**34.** The composition of Claim 33 wherein R is a hydrogen atom.

**35.** The method of Claim 2 wherein the silica source comprises at least one pentarfluoro-sulfuranyl group.

**36.** A top coat for use in a lithographic process prepared by:

applying a layer of a composition adjacent to a layer of photoresist, the composition comprising a silicon-containing polymer prepared by sol-gel processing at least one silica source, wherein the layer is ready for use as a top coat; and
optionally subjecting the layer of top coat material to a temperature of from about 50 to about 200°C,

wherein the silicon-containing polymer in the top coat material depolymerizes upon exposure to an aqueous base-containing solution.

**37.** The top coat of Claim 36 wherein the at least one silica source comprises at least one silica source of the formula $R_aSi(OR^1)_{4-a}$,
wherein:

R independently represents a hydrogen atom, a fluorine atom, a fluoroalky group, a perfluoroalkyl group, or a monovalent organic group;
$R^1$ independently represents a monovalent organic group; and
a is an integer ranging from 1 to 3.

**38.** The top coat of Claim 37 wherein R is a hydrogen atom.

**39.** The top coat of Claim 37 wherein the at least one silica source is at least one compound selected from the group consisting of methyltrimethoxysilane, methyltriethoxysilane, methyltri-n-propoxysilane, methyltriisopropoxysilane, ethyltrimethoxysilane, ethyltriethoxysilane, dimethyldimethoxysilane, dimethyldiethoxysilane, diethyldimethoxysilane, diethyldiethoxysilane, trimethoxysilane, triethoxysilane, tri-n-propoxysilane, triisopropoxysilane, tri-n-butoxysilane, tri-sec-butoxysilane, tri-tert-butoxysilane, and andtriphenoxysilane.

**40.** The top coat of Claim 39 wherein the at least one silica source comprises triethoxysilane.

**41.** The top coat of Claim 37 wherein the at least one silica source comprises Si, O, H, C, and F.

**42.** The top coat of Claim 37 wherein the silica source comprises at least one fluoroalkyl group.

**43.** The top coat of Claim 37 wherein the silica source comprises at least one perfluoroalkyl group.

**44.** The top coat of Claim 41 wherein the at least one silica source comprises at least one compound selected from the group consisting of 3,3,3-trifluoropropyltrimethoxysilane, pentafluorophenyltriethoxysilane, pentafluorophenylpropyltrimethoxysilane, (tridecafluoro-1,1,2,2-tetrahydrooctyl)-triethoxysilane, (tridecafluoro-1,1,2,2-tetrahydrooctyl)trimethoxysilane, 1H, 1H,2H,2H-perfluorodecyltriethoxysilane, nonafluorohexyltrimethoxysilane, heptadecafluoro-1,1,2,2-tetrahydrodecyl)trimethoxysilane, and (heptadecafluoro-1,1,2,2-tetrahydrodecyl)triethoxysilane.

**45.** The top coat of Claim 41 wherein the at least one silica source comprises 3,3,3-trifluoropropyltrimethoxysilane.

**46.** The top coat of Claim 36 wherein the at least one silica source comprises:

at least one compound selected from the group consisting of methyltrimethoxysilane, methyltriethoxysilane, methyltri-n-propoxysilane, methyltriisopropoxysilane, ethyltrimethoxysilane, ethyltriethoxysilane, dimethyldimethoxysilane, dimethyldiethoxysilane, diethyldimethoxysilane, diethyldiethoxysilane, trimethoxysilane, triethoxysilane, tri-n-propoxysilane, triisopropoxysilane, tri-n-butoxysilane, tri-sec-butoxysilane, tri-tert-butoxysilane, and andtriphenoxysilane; and
at least one compound selected from the group consisting of 3,3,3-trifluoropropyltrimethoxysilane, pentafluorophenyltriethoxysilane, pentafluorophenylpropyltrimethoxysilane, (tridecafluoro-1,1,2,2-tetrahydrooctyl)-triethoxysilane, (tridecafluoro-1,1,2,2-tetrahydrooctyl)trimethoxysilane, 1 H, H,2H,2H-perfluorodecyltriethoxysilane, nonafluorohexyltrimethoxysilane, heptadecafluoro-1,1,2,2-tetrahydrodecyl)trimethoxysilane, and (heptadecafluoro-1,1,2,2-tetrahydrodecyl)triethoxysilane.

**47.** The top coat of Claim 46 wherein the at least one silica source comprises triethoxysilane and 3,3,3-trifluoropropyltrimethoxysilane.

**48.** The top coat of any one of Claims 37 to 47 wherein the top coat further comprises a chromophore.

**49.** The top coat of Claim 48 wherein the chromophore comprises 5,8-dihydroxy-1,4-napthoquinone.

**50.** The top coat of Claim 48 wherein the chromophore comprises 2,4-hexadienoic acid.

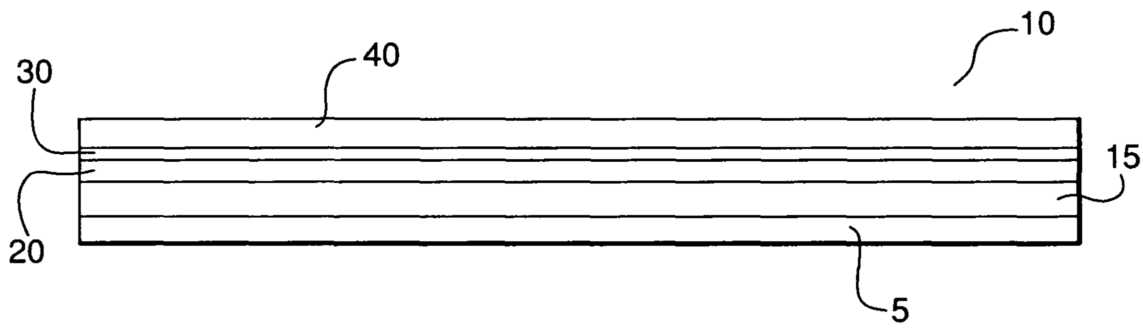


FIG. 1

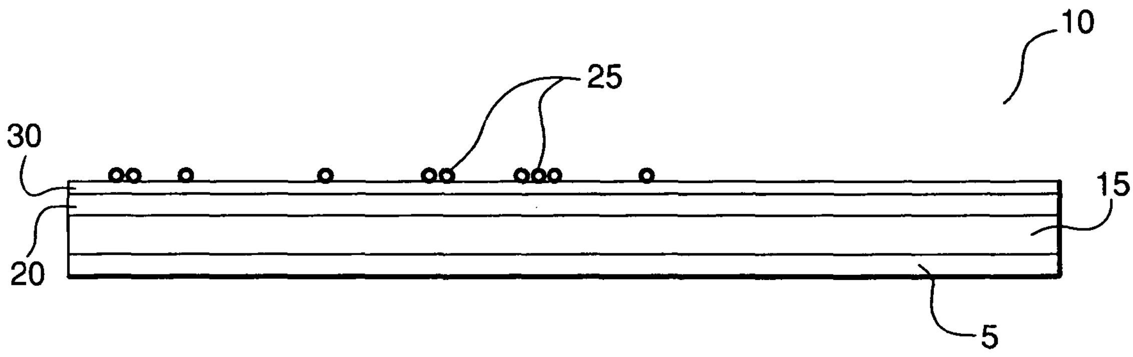


FIG. 2

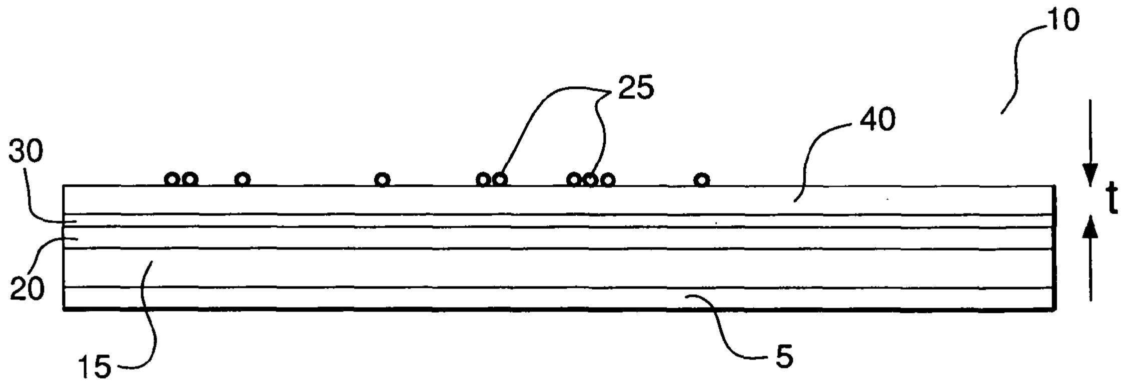


FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 77661006 P
- US 20050202347 A1
- US 20050202340 A1
- US 7060634 B
- US 7062145 B
- US 6479645 B
- US 7060846 B
- US 6870068 B
- US 6958415 B
- US 6258407 B
- US 6455234 B
- US 6268115 B
- US 6238849 B
- US 6127101 A
- US 6120978 A


### Non-patent literature cited in the description


- **C. JEFFREY BRINKER ; GEORGE W. SCHERER.** Sol-Gel Science: The Physics and Chemistry of Sol-Gel Processing. Academic Press, 1990